(19) Europäisches Patentamt
European Patent Office
Office européen des brevets

(11) **EP 3 828 578 A1**

(12) **EUROPÄISCHE PATENTANMELDUNG**

(43) Veröffentlichungstag:
**02.06.2021 Patentblatt 2021/22**

(51) Int Cl.:
***G01R 33/54*** *(2006.01)* ***G01R 33/28*** *(2006.01)*

(21) Anmeldenummer: **19212030.1**

(22) Anmeldetag: **28.11.2019**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
**KH MA MD TN**

(71) Anmelder: **Siemens Healthcare GmbH**
**91052 Erlangen (DE)**

(72) Erfinder:
• **Grodzki, David**
**91058 Erlangen (DE)**

• **Hölscher, Uvo**
**91056 Erlangen (DE)**
• **Kartäusch, Ralf**
**91088 Bubenreuth (DE)**
• **Köglmeier, Christian**
**90482 Nürnberg (DE)**
• **Löffler, Thomas**
**91054 Erlangen (DE)**
• **Meyer, Stefan**
**91094 Langensendelbach (DE)**
• **Schmitt, Peter**
**91085 Weisendorf (DE)**

(54) **VERFAHREN ZUR EINSTELLUNG EINER MRT-SEQUENZ**

(57)    Die Erfindung betrifft ein Verfahren zur Einstellung einer MRT-Sequenz sowie eine Magnetresonanzvorrichtung und ein Computerprogrammprodukt, die ausgebildet sind, ein Verfahren zur Einstellung einer MRT-Sequenz auszuführen. Ein vorgeschlagenes Verfahren umfasst folgende Schritte: Durch eine Limitationsbereitstellungseinheit wird zumindest eine Limitation bereitgestellt. Durch eine Parameterbereitstellungseinheit werden mehrere Parameter der Sequenz bereitgestellt, wobei zumindest einem der mehreren Parameter ein voreingestellter Parameterwert zugeordnet ist. Einer der mehreren Parameter wird mittels einer Auswahleinheit ausgewählt. Eine Simulationseinheit ermittelt zumindest einen Sequenzverlauf anhand von zumindest einem der voreingestellten Parameterwerte. Eine Auswerteeinheit ermittelt anhand des zumindest einen Sequenzverlaufs und anhand der zumindest einen Limitation einen zulässigen Parameterwertebereich des ausgewählten Parameters. Innerhalb des zulässigen Parameterwertebereichs wird mittels einer Festlegungseinheit ein neuer Parameterwert festgelegt. Dabei umfasst die Ermittlung eines zulässigen Parameterwertebereichs des ausgewählten Parameters anhand des zumindest einen Sequenzverlaufs und der zumindest einen Limitation durch eine Auswerteinheit wenigstens eine der folgenden Iterationen. Im Rahmen jeder Iteration erfolgt eine Simulation der Durchführung des Sequenzverlaufs der Magnetresonanztomographie mit dem voreingestellten Parameterwert. Sofern bei der Simulation alle Limitationen eingehalten werden, wird die aktuelle Iteration abgebrochen. Wenn nicht, wird die Art des Nichteinhaltens der zumindest einen Limitation bestimmt und basierend auf der Art des Nichteinhaltens der voreingestellte Parameterwert für eine nachfolgende Iteration geändert.

FIG 2

**Beschreibung**

Die Erfindung betrifft ein Verfahren zur Einstellung einer MRT-Sequenz sowie eine Magnetresonanzvorrichtung und ein Computerprogrammprodukt, die ausgebildet sind, ein Verfahren zur Einstellung einer MRT-Sequenz auszuführen.

Um eine Magnetresonanztomographie (MRT, engl. magnetic resonance imaging, MRI) eines Untersuchungsobjekts mit einer Magnetresonanzvorrichtung durchzuführen, werden mit Hilfe einer Hochfrequenzantenneneinheit hochfrequente Anregungspulse erzeugt, mit deren Hilfe Atomspins aus ihren Gleichgewichtszuständen gebracht werden. In der Folge entsteht ein messbares Magnetresonanzsignal, welches von der Hochfrequenzantenneneinheit ausgelesen wird. Um diesem Magnetresonanzsignal eine Ortsinformation zu verleihen, werden mit Hilfe einer Gradientenspuleneinheit Magnetfeldgradienten erzeugt. Der zeitliche Ablauf der Anregung und Auslesung der Magnetresonanzsignale sowie der Erzeugung der Magnetfeldgradienten wird durch eine Sequenz festgelegt.

Je nachdem welches Untersuchungsziel verfolgt werden soll, können unterschiedliche Sequenztypen, wie z.B. eine Gradientenechosequenz und/oder eine Spinechosequenz, angewandt werden. Eine Sequenz umfasst zumeist mehrere Repetitionen, mit denen unterschiedliche Bereiche eines Messraums, der oft auch k-Raum und/oder Ortsfrequenzraum genannt wird, akquiriert werden können. Eine Sequenz wird üblicherweise mittels Parametern, wie z.B. Repetitionszeit (TR), Echozeit (TE), Flipwinkel, Auslesebandweiten etc., beschrieben. Mit Hilfe einer Benutzerschnittstelle kann ein Bediener üblicherweise Parameterwerte für diese Parameter eingeben.

Durch verschiedenste Abhängigkeiten und/oder Wechselwirkungen zwischen diesen Parametern, die unter anderem vom gewählten Sequenztyp sowie von der Ausgestaltung der Magnetresonanzvorrichtung abhängen, beeinflussen sich die zur Verfügung stehenden Bereiche der Parameterwerte gegenseitig, so dass nur bestimmte Parameterkonstellationen möglich sind.

In der DE 10 2016 200 549 A1 wird ein Verfahren vorgeschlagen, mit welchem einem Bediener eine große Anzahl an Parameterkonstellationen zur Einstellung einer Sequenz ermöglicht wird.

Aufgabe der vorliegenden Erfindung ist es, dem Bediener schneller eine mögliche Parameterkonstellation bereitzustellen.

Die Aufgabe wird durch die Merkmale der unabhängigen Ansprüche gelöst. Vorteilhafte Ausgestaltungen sind in den Unteransprüchen beschrieben.

Vorgeschlagen wird ein Verfahren zur Einstellung einer Sequenz einer Magnetresonanztomographie folgende Schritte: Durch eine Limitationsbereitstellungseinheit wird zumindest eine Limitation bereitgestellt. Durch eine Parameterbereitstellungseinheit werden mehrere Parameter der Sequenz bereitgestellt, wobei zumindest einem, idealerweise jedem, der mehreren Parameter ein voreingestellter Parameterwert zugeordnet ist. Einer der mehreren Parameter wird mittels einer Auswahleinheit ausgewählt. Eine Simulationseinheit ermittelt zumindest einen Sequenzverlauf anhand von zumindest einem der voreingestellten Parameterwerte. Eine Auswerteeinheit ermittelt anhand des zumindest einen Sequenzverlaufs und anhand der zumindest einen Limitation einen zulässigen Parameterwertebereich des ausgewählten Parameters. Innerhalb des zulässigen Parameterwertebereichs wird mittels einer Festlegungseinheit ein neuer Parameterwert festgelegt. Dabei umfasst die Ermittlung eines zulässigen Parameterwertebereichs des ausgewählten Parameters anhand des zumindest einen Sequenzverlaufs und der zumindest einen Limitation durch eine Auswerteinheit wenigstens eine der folgenden Iteration. Im Rahmen jeder Iteration wird eine Simulation der Durchführung des Sequenzverlaufs der Magnetresonanztomographie mit dem voreingestellten Parameterwert. Sofern bei der Simulation alle Limitationen eingehalten werden, wird die aktuelle Iteration abgebrochen. Wenn nicht, wird die Art des Nichteinhaltens der zumindest einen Limitation bestimmt und basierend auf der Art des Nichteinhaltens der voreingestellte Parameterwert für eine nachfolgende Iteration geändert.

Da es sich bei der Simulationseinheit und/oder die Auswerteeinheit vorzugsweise um weitgehend von einer Sequenz unabhängig arbeitende Einheiten handelt, ist das vorgeschlagene Verfahren im Vergleich zu Verfahren, die für spezifische Sequenzen zugeschnitten sind, einfach für beliebige Sequenzen anwendbar.

Das Verfahren kann natürlich mehrmals durchgeführt werden, um beispielsweise mehrere neue Parameterwerte, insbesondere verschiedener Parameter, festzulegen. So kann iterativ eine Sequenz eingestellt und/oder optimiert werden.

Der zulässige Parameterwertebereich kann insbesondere zusammenhängend oder unterbrochen sein, d.h. mehrere nichtzusammenhängende Intervalle umfassen. Die Festlegung des neuen Parameterwertes innerhalb des zulässigen Parameterwertebereichs kann automatisch und/oder bedienerseitig erfolgen. Bei einer bedienerseitigen Festlegung kann der Bediener idealerweise komfortabel einen möglichen Parameterwert für den ausgewählten Parameter einstellen. Dazu wird dem Bediener bevorzugt mit einer Ausgabeeinheit, beispielsweise einem Bildschirm, der zulässige Parameterwertebereich angezeigt. Diese Anzeige kann insbesondere farblich und/oder grafisch kodiert erfolgen, um dem Bediener die Festlegung des neuen Parameterwertes zu erleichtern. Vorteilhafterweise kann anhand des neuen Parameterwertes eine Messdatenaufnahme durch die Magnetresonanzvorrichtung erfolgen.

Unter einer Limitation kann eine Bedingung verstanden werden, deren Erfüllung zum Betrieb vorteilhaft, insbesondere notwendig und/oder unumgänglich, ist. Die zumindest eine Limitation kann zumindest eine Gerätelimitation und/oder zumindest eine Applikationslimitation umfassen.

Unter einer Gerätelimitation kann insbesondere eine Beschränkung verstanden werden, die durch eine Ausgestaltung der Magnetresonanzvorrichtung, mit der die Magnetresonanztomographie durchgeführt werden soll, gegeben ist. Beispielhaft seien eine maximale Gradientenamplitude und/oder eine maximale Gradientenanstiegsrate (engl. slew rate) genannt, welche durch eine Gradientenspuleneinheit der Magnetresonanzvorrichtung erzeugt werden können. Unter einer Gradientenanstiegsrate kann üblicherweise der Betrag der zeitlichen Ableitung der Gradientenamplitude verstanden werden, d.h. es soll darunter vor allem eine vorzeichenunabhängige Änderungsrate der Gradientenamplitude verstanden werden.

Unter einer Applikationslimitation kann insbesondere eine Beschränkung verstanden werden, die durch eine Beeinflussung der Magnetresonanzvorrichtung und/oder eines Untersuchungsobjekts, insbesondere ein menschlicher oder tierischer Patient, aufgrund einer Durchführung einer Sequenz gegeben ist. So ist es beispielsweise möglich, dass durch eine Applikation zu hoher Gradientenamplituden eine zu starke Erwärmung der Magnetresonanzvorrichtung oder eines Teils der Magnetresonanzvorrichtung verursacht wird. Neben technischen können auch physiogische Grenzen gegeben sein. Beispielsweise können durch einen falschen Betrieb der Magnetresonanzvorrichtung periphere Nerven des Patienten zu stark stimuliert werden.

Die zumindest eine Limitation kann zumindest einen, vorzugsweise einstellbaren, Sicherheitspuffer umfassen. Beispielsweise wird als Limitation kein physikalischer und/oder physiologisch gerader noch möglicher Grenzwert bereitgestellt, sondern einen Wert, der in einer konservativen Weise von einem maximal möglichen Grenzwert abweicht. Somit kann die Betriebssicherheit der Magnetresonanzvorrichtung erhöht werden. Die zumindest eine Limitation kann in einer Datenbank gespeichert sein, worauf die Limitationsbereitstellungseinheit zugreift. Vorteilhafterweise übermittelt die Limitationsbereitstellungseinheit die zumindest eine Limitation an die Auswerteeinheit.

Vorteilhafterweise sind die mehreren Parameter geeignet, die Sequenz zu beschreiben und/oder festzulegen. Beispielhafte Parameter sind eine Repetitionszeit (TR) und/oder eine Echozeit (TE) und/oder ein Flipwinkel und/oder eine Auslesebandbreite und/oder eine Schichtorientierung und/oder ein Bildbereich (FoV, engl. field of view).

Die mehreren Parameter und/oder die den Parametern zugeordneten voreingestellten Parameterwerte können in einer Datenbank gespeichert sein, worauf die Parameterbereitstellungseinheit zugreift. Vorteilhafterweise übermittelt die Parameterbereitstellungseinheit die mehreren Parameter und/oder die Parameterwerte an die Ausgabeeinheit, um diese und/oder davon abgeleitete Parameter und/oder Parameterwerte dem Bediener zumindest teilweise anzuzeigen.

Die Auswahl kann bedienerseitig und/oder automatisch ausgeführt werden. Bei einer bedienerseitigen Auswahl umfasst die Auswahleinheit vorteilhafterweise eine Eingabeeinheit, die beispielsweise einen Bildschirm aufweist. Die bedienerseitige Auswahl geschieht beispielsweise, indem der Bediener auf dem Bildschirm ein Eingabefeld anwählt, das dem gewünschten Parameter zugeordnet ist. Dieses Eingabefeld kann z.B. bereits einen voreingestellten Parameterwert aufweisen, der in der Folge z.B. durch manuelle Eingabe eines neuen Parameterwertes verändert werden kann. Eine automatische Auswahl kann insbesondere derart ausgebildet sein, dass die Sequenz z.B. hinsichtlich einer Zeitdauer optimiert wird, ohne dass ein Bediener manuell eingreifen muss.

Ein Sequenzverlauf bildet üblicherweise einen zeitlichen Ablauf von Sequenzereignissen, wie z.B. Anregungspulsen und/oder Gradientenpulsen und/oder Auslesevorgängen ab. Unter der Ermittlung des zumindest einen Sequenzverlaufs kann ein zeitliches Ausrollen der Sequenz verstanden werden. Die Ermittlung des zumindest einen Sequenzverlaufs erfolgt insbesondere anhand von einem oder mehreren Parameterwerten, die nicht dem ausgewählten Parameter zugeordnet sind.

Die Ermittlung eines Sequenzverlaufs kann eine Berechnung einer Wertetabelle umfassen, wobei die Wertetabelle eine erste Spalte und eine zweite Spalte umfasst, wobei die erste Spalte zumindest einen Zeitwert und die zweite Spalte zumindest einen dem zumindest einen Zeitwert zugeordneten Verlaufswert umfasst. Dabei entspricht üblicherweise ein Zeitwert einem Zeitpunkt des Sequenzverlaufs, so dass aus der Anzahl der Zeitpunkte des Sequenzverlaufs die Anzahl der Zeilen der Wertetabelle resultiert. Die Verlaufswerte sind üblicherweise abhängig von zumindest einem der Parameterwerte.

Mögliche Verlaufswerte können beispielsweise Gradientenamplituden sein, die auf einer physikalischen Gradientenachse der Gradientenspuleneinheit, nämlich den physikalischen Gradientenachsen, angewendet werden sollen. Ein Gradientenamplituden umfassender Sequenzverlauf berücksichtigt vorzugsweise Korrekturgradienten und/oder Kompensationsgradienten, insbesondere Wirbelstromkompensationsgradienten, so dass der Sequenzverlauf die tatsächliche Anwendung der Gradientenspuleneinheit abbildet. Somit arbeitet ein Verfahren gemäß diesem Aspekt möglicherweise genauer als bei einer etwaigen Betrachtung in abstrahierter Form.

Die Gradientenspuleneinheit umfasst typischerweise drei physikalische Gradientenachsen, die als x-, y- und z-Achse bezeichnet werden können. Bei einer Magnetresonanzvorrichtung mit einem zylinderförmigen Patientenaufnahmebereich entspricht die z-Achse oftmals der Zylinderachse des Patientenaufnahmebereichs. Als y-Achse wird oftmals eine zur z-Achse rechtwinklige vertikale Achse definiert und als x-Achse eine zur y-Achse und z-Achse rechtwinklige horizontale Achse.

Auf jeder der drei physikalischen Gradientenachsen kann üblicherweise nur eine begrenzte Gradientenamplitude, nämlich eine maximale Gradientenamplitude, angewandt werden, welche üblicherweise mit einer begrenzten Gradientenanstiegsrate, nämlich der maximalen Gradientenanstiegsrate, verändert werden kann.

Von den physikalischen Gradientenachsen können logische Gradientenachsen unterschieden werden. Die logischen Gradientenachsen umfassen üblicherweise eine Schichtselektionsgradientenachse, eine Phasenkodiergradientenachse und eine Frequenzkodiergradientenachse, welche in der Regel ein dreidimensionales rechtwinkliges Koordinatensystem bilden. Die relative Lage der logischen Gradientenachsen zu den physikalischen Gradientenachsen legt üblicherweise die Orientierung des Messbereichs, insbesondere einer zu messenden Schicht, fest.

Parallel zur Schichtselektionsgradientenachse wird üblicherweise Schichtselektionsgradient appliziert. Mit Hilfe von Schichtselektionsgradientenpulse, oft auch verkürzend Schichtselektionsgradienten genannt, können gezielt Atomkerne in einer gewünschten Schicht angeregt werden. Ferner werden üblicherweise parallel zur Phasenkodiergradientenachse Phasenkodiergradientenpulse, oft auch verkürzend Phasenkodiergradienten genannt, und parallel zur Frequenzkodiergradientenachse Frequenzkodiergradientenpulse, oft auch verkürzend Frequenzkodiergradienten genannt, appliziert. Phasenkodiergradient und Frequenzkodiergradient ermöglichen in der Regel eine Ortskodierung der Magnetresonanzsignale in der angeregten Schicht. Der Frequenzkodiergradient kann auch als Auslesegradient bezeichnet werden, da er üblicherweise zeitgleich während des Auslesens der Magnetresonanzsignale angewandt wird.

Üblicherweise weichen je nach Orientierung und/oder Kippung des Messbereichs und/oder der Messschicht die logischen Gradientenachsen also von den physikalischen Gradientenachsen ab, so dass sich die Gradientenpulse der logischen Gradientenachsen abhängig von der Orientierung und/oder Kippung des Messbereichs und/oder der Messschicht auf die physikalischen Gradientenachsen verteilen.

Vorzugsweise umfasst der zumindest eine Sequenzverlauf mehrere Zeitpunkte. Um festzustellen, ob ein bestimmter Parameterwert des gewählten Parameters zulässig ist, also innerhalb des zulässigen Parameterwertebereichs liegt, wird vorzugsweise jeder der Zeitpunkte hinsichtlich der zumindest einen Limitation untersucht. Dagegen ist es in der Regel ausreichend, nur einen Zeitpunkt zu finden, in dem die zumindest eine Limitierung nicht erfüllt ist, um festzustellen, dass der Parameterwert des Sequenzverlaufs nicht zulässig ist, so dass die Untersuchung des Sequenzverlaufs abgebrochen werden kann.

Bezogen auf das ausgeführte Beispiel wird entsprechend für jeden Zeitwert der Wertetabelle ermittelt, welche Parameterwerte möglich sind, ohne dass die zu diesem Zeitwert gehörige Gradientenamplitude eine maximale Gradientenamplitude übersteigt. Analog kann auch die Gradientenanstiegsrate überprüft werden.

Bevorzugt werden zur Ermittlung des zulässigen Parameterwertebereichs des ausgewählten Parameters verschiedene Testparameterwerte für den Parameterwert des angewählten Parameters ermittelt, d.h. der Parameterwert des angewählten Parameters kann variiert werden. Für jeden der Testparameterwerte wird bevorzugt zumindest ein Sequenzverlauf ermittelt, der hinsichtlich der zumindest einen Limitation durch eine Auswerteeinheit überprüft wird. Durch Variation eines Parameterwertes, insbesondere des Parameterwertes des gewählten Parameters, können also verschiedene Testsequenzverläufe ermittelt werden. Beispielsweise werden für einen ersten Parameterwert ein erster Testsequenzverlauf, einen zweiten Parameterwert ein zweiter Testsequenzverlauf, usw. ermittelt.

Sofern die zumindest eine Limitation mehrere, also mehr als eine, Limitationen umfasst, kann die Art des Nichteinhaltens angeben, welche der Limitationen nicht eingehalten wird und darauf basierend der Parameterwert geändert werden. Wird beispielsweise eine Überschreitung einer maximalen Gradientenanstiegsrate oder einer maximalen Stimulation festgestellt, kann gezielt der voreingestellte Parameterwert der Sequenz für eine Gradientenanstiegsrate gesenkt werden. Eine Änderung von Parameterwerten anderer Parameter, beispielsweise einer Repetitionszeit und/oder eine Echozeit, hat häufig nur einen geringen Einfluss auf die Gradientenanstiegsrate. Ebenso kann bei einer Nichteinhaltung der Erwärmung (Gnom) gezielt eine Repetitionszeit oder eine Anzahl von Schicht reduziert werden, um die entsprechende Limitation einzuhalten. Durch die gezielte Änderung Parameterwertes basierend auf der festgestellten Art der Überschreitung der Limitation, kann somit schneller ein Sequenzverlauf gefunden werden, der die vorgegebenen Limitationen einhält.

In einem weiteren Ausführungsbeispiel kann die Art der Nichteinhaltung angeben, um welchen quantitativen Wert die zumindest eine Limitation nicht eingehalten worden ist. Aus dem quantitativen Wert kann beispielsweise abgeleitet werden, um welchen Wert der voreingestellte Parameterwert für die nächste Iteration geändert wird. Wenn die Simulation beispielsweise eine Überschreitung des maximalen Erwärmungswertes (Gnom) um 150% ergibt, könnte der Wert für die Repetitionszeit (TR) für die nächste Iteration um geringfügig weniger als 150% erhöht werden. Dadurch kann die Bestimmung möglicher Parameterwerte weiter beschleunigt werden.

Ein Ausführungsbeispiel sieht des Verfahrens sieht vor, dass die Änderung des voreingestellten Parameterwertes von einem Bediener vorgenommen wird. Der Bediener kann aufgrund seiner Erfahrung häufig basierend auf der Art des Nichteinhaltens der zumindest einen Limitation eine sinnvolle Änderung des Parameterwertes vorschlagen, welche schnell zu einem zulässigen Sequenzverlauf führt, der die Limitation(en) einhält. Ein Ausführungsbeispiel sieht des Verfahrens sieht vor, dass dem Bediener zur Änderung des voreingestellten Parameterwertes eine Auswahl an Optionen bereitgestellt wird, wobei jede Option eine jeweilige Änderung des voreingestellten Parameterwertes vorsieht, wobei jeder Option ein dem Bediener bereitgestelltes Qualitätsmerkmal einer Magnetresonanzabbildung zugeordnet ist, das bei Auswahl der Option durch den entsprechend geänderten Parameterwert erreichbar ist.

Durch das dem Bediener bereitgestellte Qualitätsmerkmal kann dem Bediener, insbesondere anstatt technischer Parameter, ein Einfluss der Änderung des voreingestellten Parameterwertes auf das Ergebnis der Magnetresonanztomographie, insbesondere auf durch die geänderte Sequenz zu erzeugende Magnetresonanzabbildungen, dargelegt werden. Beispielsweise kann der Bediener zwischen den Qualitätsmerkmalen "Signalrauschverhältnis (SNR) gleich, verringertes Kontrastrauschverhältnis (CNR)", "verringertes SNR, gleiches CNR" oder anderen jeweils einer Option zugeordneter Qualitätsmerkmal auswählen.

In einer Ausgestaltung wird die Kombination aus festgestellter Art des Nichteinhaltens und vom Bediener ausgewählter Änderung des Parameterwerts verwendet, um einen Auswahlalgorithmus zu trainieren.

Anstelle einer direkten Auswahl des Parameterwerts kann durch den Bediener auch eine Vorgabe für das Ergebnis der Simulation gegeben werden. Beispielsweise kann der Bediener vorgeben, dass bei gleichem Signalrauschverhältnis (SNR) ein verringertes Kontrastrauschverhältnis (CNR) akzeptabel ist. Darauf basierend kann mittels des Verfahrens der Parameterwert automatisiert geändert werden. In einem anderen Ausführungsbeispiel kann ein verringerte Auflösung bei gleichem Kontrastrauschverhältnis akzeptabel sein. Es ist auch möglich, dass eine entsprechende Präferenz des Bedieners zu Beginn des Verfahrens eingegeben wird.

In einer weiteren Ausgestaltung kann ein trainierter Auswahlalgorithmus verwendet werden, um die Änderung des Parameterwertes basierend auf der Art der Nichteinhaltung durchzuführen. Mit anderen Worten kann die Erfahrung eines Bedieners für weitere Bediener und/oder einer stärkere Automatisierung nutzbar gemacht werden.

Bei mehreren Limitationen können diese in einer vorgegebenen Reihenfolge untersucht werden. Beispielsweise kann als eine erste Limitation eine maximale Gradientenamplitude, als zweite Limitation eine maximale Gradientenanstiegsrate, als dritte Limitation eine maximale Stimulation und als vierte Limitation eine maximale Erwärmung untersucht werden. Insbesondere kann eine Untersuchung abgebrochen werden, sobald eine Limitation nicht erfüllt ist. Durch eine Priorisierung der mehreren Limitationen kann die Ermittlung eines zulässigen Parameterwertebereichs effizient erfolgen.

Eine Ausführungsform sieht vor, dass der zumindest eine Sequenzverlauf einen Teilabschnitt der Sequenz beschreibt. Es ist also denkbar, dass der zumindest eine Sequenzverlauf nicht notwendigerweise für eine komplette Sequenz erzeugt wird, sondern nur für einen bestimmten Teil der Sequenz. Vorteilhafterweise ist der Teilabschnitt repräsentativ für die gesamte Sequenz, so dass aus einer Untersuchung dieses Teilabschnitts auf den zulässigen Parameterwertebereich des ausgewählten Parameters für die gesamte Sequenz geschlossen werden kann, beispielsweise durch Extrapolation.

Bevorzugt beschreibt der Sequenzverlauf einen Teilabschnitt der Sequenz, durch den äußere k-Raum-Punkte kodiert werden. Vorzugsweise liegen derartige äußere k-Raum-Punkte bezogen auf den gesamten k-Raum vom Zentrum des k-Raums mindestens 70%, bevorzugt mindestens 80%, besonders bevorzugt mindestens 90% entfernt.

Eine Ausführungsform sieht vor, dass der zulässige Parameterwertebereich mit Hilfe einer lückenlosen Suche und/oder einer Binärsuche, insbesondere einer Intervallschachtelung, ermittelt wird.

Bevorzugt wird bei der lückenlosen Suche und/oder Binärsuche ein zu untersuchender Parameterwertebereich diskretisiert, d.h. er in eine endliche Anzahl von möglichen Parameterwerten zerlegt. Vorzugsweise erfolgt diese Zerlegung mit konstantem Inkrement, d.h. jeder möglicher Parameterwert weist zu einem nächstliegenden möglichen Parameterwert einen gleichen Abstand auf. Es ist aber auch denkbar, dass die Abstände variieren.

Eine lückenlose Suche eignet sich vor allem bei nicht-konvexen Parameterbereichen, d.h. zwischen einem gültigen Minimum und einem gültigen Maximum des nicht-konvexen Parameterbereiches existieren ungültige Werte. Unter einem gültigen Wert soll hier ein Parameterwert verstanden werden, durch dessen Anwendung die zumindest eine Bedingung eingehalten wird. Entsprechend soll hier unter einem ungültigen Wert ein Parameterwert verstanden werden, für den dies nicht der Fall ist. Dies betrifft z.B. Rotationswinkel, die eine relative Lage logischer Gradientenachsen zu physikalischen Gradientenachsen beschreiben.

Bevorzugt wird bei der lückenlosen Suche nacheinander für verschiedene, beispielsweise aufeinander folgende, Parameterwerte jeweils ein Sequenzverlauf ermittelt und überprüft ob der jeweilige Parameterwert zulässig ist. Bei einer lückenlosen Suche müssen bei N möglichen Parameterwerten üblicherweise auch alle N Parameterwerte als Testparameterwerte untersucht werden.

Eine Binärsuche, oft auch binäre Suche genannt, grenzt den zulässigen Parameterwertebereich effizient schrittweise ein.

Bei einer Binärsuche liegen üblicherweise ein erster Startparameterwert und zweiter Startparameterwert vor. Vorzugsweise wird bei Verwendung des ersten Startparameterwerts die zumindest eine Limitation erfüllt. In einem ersten Schritt der Binärsuche wird als erster Testparameterwert ein Parameterwert hinsichtlich der zumindest einen Limitation untersucht, der mittig zwischen dem ersten und dem zweiten Startparameterwert liegt, d.h. es wird überprüft, ob bei Anwendung dieses Testparameterwertes die eine oder mehreren Limitationen eingehalten werden. Ein mittiger Parameterwert teilt vorteilhafterweise eine Menge an zu untersuchenden Testparameterwerte in zwei Teilmengen, deren Anzahlen an Testparameterwerten sich höchstens um eins unterscheiden.

Falls die Untersuchung des ersten Testparameterwertes ergibt, dass die zumindest eine Limitation eingehalten wird, dann wird in einem zweiten Schritt als zweiter Testparameterwert ein Parameterwert untersucht, der mittig zwischen dem zweiten Startparameterwert und dem ersten Testparameterwert liegt. Anderenfalls wird als zweiter Testparameterwert ein Parameterwert untersucht, der mittig zwischen dem ersten Startparameterwert und dem ersten Testparameterwert liegt. Nach diesem Prinzip wird der zulässige Parameterbereich immer weiter eingegrenzt, bis ein äußerer Parameterwert gefunden wird, bei dessen Anwendung die zumindest eine Bedingung gerade noch eingehalten wird, d.h. dem äußere Parameterwert ist ein Parameterwert benachbart, der die zumindest eine Limitation verletzt. Diese Methode ist besonders effizient, da die Länge des Suchbereiches von Schritt zu Schritt halbiert wird, so dass üblicherweise bei N möglichen Parameterwerten nur $\log_2(N+1)$ Testparameterwerte untersucht werden müssen.

Falls die Binärsuche ergibt, dass auch bei Anwendung des zweiten Startparameterwerts die zumindest Limitationen erfüllt werden, erfolgt vorteilhafterweise eine neue Binärsuche, bei der der untersuchte Parameterwertebereich über den zweiten Startparameterwert hinaus erweitert wird, d.h. der zweite Startparameterwert fungiert in der weiteren Binärsuche als neuer erster Startparameterwert und es wird ein neuer zweiter Startparameterwert gewählt, der eine größere Differenz zum ersten Startparameterwert aufweist als zum zweiten Startparameterwert der ursprünglichen Binärsuche.

Binärsuchen sind besonders vorteilhaft bei konvexen Parameterbereichen. Ein konvexer Parameterbereich weist üblicherweise ein Minimum und ein Maximum auf, zwischen denen alle Werte gültig sind. Für viele Parameter, wie z.B. der Echozeit, der Repetitionszeit und/oder dem Bildbereich ist diese Annahme in der Regel gültig.

Vorzugsweise wird aus der zumindest einen Limitation der erste Startparameterwert und der zweiter Startparameterwert für die Binärsuche abgeleitet. So ist es denkbar, dass sich mittels einfacher Abschätzungsmethoden auf Basis der zumindest einen Limitation sinnvolle Startparameterwert ermitteln lassen.

Eine Ausführungsform sieht vor, dass die zumindest eine Limitationen zumindest eine absolute Limitation, insbesondere zumindest eine absolute maximale Gradientenamplitude und/oder Gradientenanstiegsrate, und zumindest eine Limitation, insbesondere zumindest eine konservative maximale Gradientenamplitude und/oder Gradientenanstiegsrate, umfasst. Dabei legen vorzugsweise die zumindest eine absolute Limitation einen absoluten Parameterwertebereich und die zumindest eine konservative Limitation einen konservativen Parameterwertebereich fest. In zumindest einem Differenzbereich von absoluten Parameterwertebereich und konservativen Parameterwertebereich kann ein zulässiger Teilparameterwertebereich ermittelt werden. Dabei umfasst der zulässige Parameterwertebereich den konservativen Parameterwertebereich und den zumindest einen zulässigen Teilparameterwertebereich.

Unter einer absoluten Limitation kann insbesondere eine Grenze verstanden werden, die immer eingehalten werden muss und/oder unter keinen Umständen überschritten werden darf. Beispielsweise kann eine Gradientenspule einer Magnetresonanzvorrichtung aufgrund ihrer elektronischen und mechanischen Ausgestaltung nur eine gewisse absolute maximale Gradientenamplitude und/oder Gradientenanstiegsrate erzeugen. Eine absolute Limitation ist üblicherweise unabhängig von etwaigen anderen Limitationen.

Eine konservative Limitation schließt vorteilhafterweise Parameterkonstellationen aus, wodurch möglicherweise eine oder mehrere absolute Limitationen überschritten werden könnten, wobei unter einer Parameterkonstellation ein Satz von Parameterwerten verstanden werden kann.

Wie bereits erwähnt, können verschiedenste Abhängigkeiten und/oder Wechselwirkungen zwischen diesen Parametern bestehen, so dass beispielsweise ein erster Parameterwert $PW_1$ eines ersten Parameters $P_1$ als eine Funktion $f$ von einem zweiten Parameterwert $PW_2$ eines zweiten Parameters $P_2$ und gegebenenfalls weiterer Parameterwerte dargestellt werden kann: $PW_1 = f(PW_2, ...)$. Eine konservative Limitation ist vorzugsweise eine Limitation, die einen zweiten Parameterwertebereich $R_2$ für den zweiten Parameter $P_2$ derart einschränkt, so dass für den zweiten Parameter $P_2$ ein beliebiger Parameterwert $PW_2$ aus dem Parameterwertebereich $R_2$ gewählt werden kann, so dass sich daraus für den ersten Parameter $PW_1$ immer ein Parameterwert $PW_1$ ergibt, der die zumindest eine Limitation erfüllt.

Vorzugsweise gilt dies für die etwaigen weiteren Parameterwerte $PW_3$. Insbesondere ist konservative Limitation vorzugsweise eine Limitation, die einen zweiten Parameterwertebereich $R_2$ für den zweiten Parameter $P_2$ derart einschränkt, so dass für einen dritten Parameter $P_3$ ein beliebiger Parameterwert $PW_3$ aus dem Parameterwertebereich $R_3$ gewählt werden kann, so dass sich daraus für den ersten Parameter $PW_1$ immer ein Parameterwert $PW_1$ ergibt, der die zumindest eine Limitation erfüllt.

Die zumindest eine konservative Limitation lässt also nur Parameterkonstellationen $PW_2$, $PW_3$, ... zu, für die der erste Parameter $P_1$ einen Parameterwert $PW_1$ annimmt, der innerhalb des zulässigen Parameterbereichs und insbesondere innerhalb eines konservativen Parameterwertebereichs $R_{1,con}$ liegt, d.h. der konservative Parameterwertebereich $R_{1,con}$ umfasst Parameterwerte $PW_1$, die sich aus der zumindest einen konservativen Limitation ergeben.

Beispielsweise kann durch eine konservative Gradientenlimitation, wie etwa eine Einschränkung der Gradientenamplituden und/oder Gradientenanstiegsraten auf den logischen Gradientenachsen, insbesondere eingeschränkt auf $1/\sqrt{3}$ der maximalen Gradientenamplituden und/oder Gradientenanstiegsraten der physikalischen Gradientenachsen, erreicht werden, dass eine absolute Gradientenlimitation, wie etwa die maximale Gradientenamplituden und/oder Gradientenanstiegsraten auf den physikalischen Gradientenachsen, in jeder relativen Lage der logischen Gradientenachsen zu den physikalischen Gradientenachsen eingehalten werden.

Übertragen auf die abstraktere Schreibweise kann beispielhaft die Gradientenamplitude auf einer physikalischen Gradientenachse als erster Parameterwert $PW_1$ angesehen werden, der höchstens eine maximale Gradientenamplitude $G_{max,phys}$ annehmen kann, d.h. $PW_1 \in [0;G_{max,phys}]$. Durch Einschränkung der Gradientenamplitude $G_{max,log}$ einer logischen Gradientenachse auf $G_{max,log}=G_{max,phys}/\sqrt{3}$, d.h. $PW_2 \in [0;G_{max,log}]$, kann ein Rotationswinkel $P_3$, der eine relativen Lage der logischen Gradientenachsen zu den physikalischen Gradientenachsen beschreibt, jeden beliebigen Rotationswert $PW_3$ annehmen, d.h. $PW_3 \in [0;360°[$.

Insbesondere ist also bei Einhaltung der zumindest einen mehkonservativen Limitation, wie z.B. einer konservativen Gradientenlimitation, zumindest ein Parameterwert der mehreren Parameter frei festlegbar, insbesondere ein Parameter, der eine Orientierung des Messbereiches festlegt wie z.B. ein Rotationsparameter.

Vorteilhafterweise muss der aus der einen oder den mehreren konservativen Limitationen abgeleitete konservativen Parameterwertebereich nicht mit beispielsweise einer Binärsuche untersucht werden, so dass das Verfahren beschleunigt werden kann. Bevorzugt wird also nur der über den konservativen Parameterwertebereich hinausgehende absolute Parameterbereich untersucht, aber nicht der gesamte absolute Parameterbereich.

Bevorzugt kann ein Parameterwert, der den konservativen Parameterbereich eingrenzt, als erster Startparameterwert der Binärsuche verwendet werden. Ferner kann bevorzugt ein Parameterwert, der den absoluten Parameterbereich eingrenzt, als zweiter Startparameterwert der Binärsuche verwendet werden.

Es sind noch weitere Varianten zur Ermittlung des zulässigen Parameterwertebereichs denkbar, bei denen auf eine lückenlose Suche und/oder eine Binärsuche ganz oder teilweise verzichtet werden kann. So sieht eine weitere Ausführungsform vor, dass die zumindest eine Limitationen zumindest eine maximale Gradienteneigenschaft für zumindest eine physikalische Gradientenachse umfasst, wobei anhand der zumindest einen maximalen Gradienteneigenschaft und des zumindest einen Sequenzverlaufs für jede der zumindest einen physikalischen Gradientenachsen ein Gradientenoptimierungswert ermittelt wird, wobei anhand des zumindest einen Gradientenoptimierungswerts der zulässige Parameterwertebereich ermittelt wird.

Insbesondere ist denkbar, dass zumindest eine maximale Gradienteneigenschaft einer logischen Gradientenachse ermittelt wird, anhand derer der zulässige Parameterwertebereich ermittelt wird. Dies geschieht z.B., in minimale Zeitdauern verschiedener Sequenzsegmente addiert werden. Eine Binärsuche, wie vorab beschrieben, ist dabei vorteilhafterweise nicht nötig.

Bevorzugt wird zur Ermittlung des zumindest einen Gradientenoptimierungswertes für jeden Zeitpunkt des Sequenzverlaufs ein Verhältnis der maximalen Gradienteneigenschaft, wie z.B. einer maximalen Gradientenamplitude und/oder einer maximalen Gradientenanstiegsrate, zu einer durch den Sequenzverlauf vorgegebenen Gradienteneigenschaft, wie z.B. einer Gradientenamplitude und/oder Gradientenanstiegsrate. Zudem kann unter einer Gradienteneigenschaft auch eine Eigenschaft verstanden werden, die von der Gradientenamplitude und/oder der Gradientenanstiegsrate abhängig sind, wie beispielsweise eine Stimulation. Dementsprechend kann unter einem Gradientenverlauf auch ein Stimulationsverlauf verstanden werden.

Der zumindest eine Sequenzverlauf ergibt sich üblicherweise aus den zumindest einem voreingestellten Parameterwerten. Vorzugsweise ist das Minimum der besagten Verhältnisse der Gradientenoptimierungswert, d.h. der Gradientenoptimierungswert kann anhand eines Minimums eines Verhältnisses der maximalen Gradienteneigenschaft zu einem Maximum des zumindest einen Sequenzverlaufs ermittelt werden.

Anhand dieses Minimums kann die vorgegebene Gradienteneigenschaft angepasst werden, insbesondere ergibt eine Multiplikation der vorgegebenen Gradienteneigenschaft mit dem Gradientenoptimierungswert eine neue Gradienteneigenschaft. Dadurch ist es möglich, die Gradienteneigenschaft auf ein optimiertes, insbesondere maximales, Niveau zu bringen, ohne eine etwaige Gradientenlimitation zu verletzen.

Der Gradientenoptimierungswert kann größer als 1 sein, d.h. die vorgegebene Gradienteneigenschaft wird angehoben. Sie kann aber auch kleiner als 1 sein, d.h. sie wird abgesenkt. Ergibt sich als Gradientenoptimierungswert der Wert 1, so bleibt die Gradienteneigenschaft in der Regel unverändert.

Aus den veränderten Gradienteneigenschaften ergeben sich in der Regel veränderte zulässige Parameterwertebereiche. So kann beispielsweise durch eine Erhöhung von Gradientenamplituden einer Erweiterung eines zulässigen Parameterwertebereichs für eine Echozeit erreicht werden, da Gradientenpulse verkürzt werden können, ohne das Moment des Gradientenpulses zu verändern, so dass auch Verkürzung der Echozeit erreicht werden kann. Somit kann beispielsweise die Zeit verringert werden, die für eine Untersuchung benötigt wird.

In einer vorteilhaften Ausgestaltung des Verfahrens wird bei der Ermittlung des zulässigen Parameterwertebereichs eine Optimierungsanalyse der Sequenz, insbesondere eines Ablaufs der Sequenz, durchgeführt. Die Optimierungsanalyse kann mit Hilfe des zumindest ein Gradientenoptimierungswertes durchgeführt werden.

Vorzugsweise wird durch die Optimierungsanalyse festgestellt, ob und/oder wodurch die zumindest eine Limitierung überschritten wird. Bevorzugt umfasst die Sequenz zumindest ein Sequenzobjekt, wie beispielsweise zumindest einen Gradientenpuls, wobei durch die Optimierungsanalyse festgestellt wird, welches Sequenzobjekt die zumindest eine Limitierung überschreitet. Mit dieser Information kann eine Rückkopplung an die Sequenz erfolgen.

Anhand der Optimierungsanalyse können mögliche Anpassungen zumindest einer Gradienteneigenschaft analysiert werden. Beispielsweise kann die Auswirkung einer Veränderung, insbesondere einer Erhöhung und/oder Erniedrigung, einer Gradientenamplitude und/oder einer Gradientenanstiegsrate auf die Sequenz getestet werden.

Bevorzugt erfolgt die Optimierungsanalyse anhand von Optimierungsregeln. Beispielsweise kann durch die Optimierungsregeln festgelegt werden, dass durch eine mögliche Reaktion der Sequenz auf ein Ergebnis der Optimierungsanalyse eine Kodierung von Magnetresonanzsignalen beibehalten werden muss, insbesondere indem das Moment von Gradientenpulsen konstant bleibt. Die Optimierungsregeln können in der Auswerteeinheit hinterlegt werden.

Ferner ist denkbar, dass die Optimierungsanalyse lediglich die Änderung bestimmter Gradientenpulse vorsieht, insbesondere derjenigen, die den zu ermittelnden Parameterwertebereich einschränken.

Eine weitere Ausführungsform sieht vor, dass die zumindest eine Limitation zumindest eine maximale Gradienteneigenschaft, insbesondere eine maximale Gradientenamplitude und/oder eine maximale Gradientenanstiegszeit, für zumindest eine physikalische Gradientenachse umfasst. Dabei ist der ausgewählte Parameter von einem Rotationswinkelparameter abhängig. Insbesondere ist der ausgewählte Parameter ein Rotationswinkelparameter. Ferner wird bei der Ermittlung des zumindest eines Sequenzverlaufs zumindest ein Sequenzverlauf einer Gradienteneigenschaft ermittelt, der mehrere Zeitpunkte umfasst. Dabei wird für jeden der mehreren Zeitpunkte eine euklidische Summe der Gradienteneigenschaft auf jeder zumindest einen physikalischen Gradientenachsen ermittelt und mit der zumindest einen maximalen Gradienteneigenschaft verglichen.

In diesem Zusammenhang kann unter einem Rotationswinkelparameter ein Winkel verstanden werden, der eine Rotation der logischen Gradientenachsen zu den physikalischen Gradientenachsen beschreibt.

Eine euklidische Summe eines Vektors $v=(v_1,v_2,v_3)$ wird üblicherweise berechnet mit $(v_1^2+v_2^2+v_2^2)^{0,5}$. In diesem Zusammenhang kann die Gradienteneigenschaft als Vektor aufgefasst werden, insbesondere die Gradientenamplitude mit $G=(G_x,G_y,G_z)$ und/oder die Gradientenanstiegszeit $S=(S_x,S_y,S_z)$, wobei $G_x$ und $S_x$ die Gradientenamplitude und die Gradientenanstiegszeit auf der x-Achse, $G_y$ und $S_y$ die Gradientenamplitude und die Gradientenanstiegszeit auf der y-Achse und $G_z$ und $S_z$ die Gradientenamplitude und die Gradientenanstiegszeit auf der z-Achse repräsentieren. Demzufolge kann die euklidische Summe der Gradientenamplitude mit $(G_x^2+G_y^2+G_z^2)^{0,5}$ und/oder die euklidische Summe der Gradientenanstiegszeit mit $(S_x^2+S_y^2+S_z^2)^{0.5}$ berechnet werden.

Da Parameterbereiche von Rotationswinkeln in der Regel nichtkonvex sind, wäre ohne eine Überprüfung mittels der euklidischen Summe möglicherweise eine lückenlose Suche notwendig, wie sie vorab beschrieben wurde. Die lückenlose Suche wäre aufgrund der üblicherweise hohen Anzahl an zu testenden Rotationswinkeln und der daraus resultierenden Sequenzverläufe relativ zeitaufwändig. Durch die Ermittlung der euklidischen Summe kann gegebenenfalls anhand nur eines Sequenzverlaufs eine Gradienteneigenschaft auf eine Erfüllung der maximalen Gradienteneigenschaft untersucht werden, d.h. es müssen nicht für eine Vielzahl von Rotationswinkelnparameterwerten Sequenzverläufe erstellt und untersucht werden.

Rotationswinkelparameter haben üblicherweise nur einen indirekten Einfluss auf das Sequenztiming, d.h. durch eine Veränderung eines Rotationswinkelparameterwertes ändert sich normalerweise das Timing innerhalb einer Sequenz nicht. Während sich beispielsweise bei einer Änderung der Echozeit und/oder der Repetitionszeit und/oder der Auslesebandweite oftmals Zeitabstände und damit auch Gradientenverläufe zwischen einzelnen Ereignisse, wie z.B. Anregung oder Auslesevorgang, ändern, bleiben diese bei einer Änderung der Rotationswinkelparameterwerte konstant. Unter einem Gradientenverlauf kann ein Verlauf einer Gradientenamplitude und/oder einer Gradientenanstiegsrate verstanden werden.

Vorzugsweise wird bei Überschreitung der maximalen Gradienteneigenschaft durch die euklidische Summe der Gradienteneigenschaft zumindest ein zulässiger Rotationswinkelparameterwert mit Hilfe einer lückenlosen Suche ermittelt. Dabei wird vorzugsweise ein Rotationswinkelparameter hinsichtlich der zumindest einen Limitationen untersucht. Die zu testenden Rotationswinkelparameterwerte können eine Rasterung aufweisen, beispielsweise können Winkel von -180° bis +180° mit Inkrementen von 0,01° untersucht werden, was eine Anzahl von 36000 Werten bedeuten würde. Da die Parameter der Sequenz üblicherweise rotationsabhängig sind und die Abhängigkeiten meist nicht-linear sind, werden vorteilhafterweise alle möglichen Werte getestet.

Eine weitere Ausführungsform des Verfahrens sieht vor, dass die Untersuchung für einen des zumindest einen Rotationswinkelwerts von Zeitpunkt zu Zeitpunkt schrittweise durchgeführt wird, wobei die Untersuchung bei Übersteigung der maximalen Gradienteneigenschaft, insbesondere der maximalen Gradientenamplitude und/oder der maximalen Gradientenanstiegsrate, durch die dem jeweiligen Zeitpunkt zugeordneten Gradienteneigenschaft abgebrochen wird.

Für einen Rotationswinkelwert, der für einen Zeitpunkt zu einer Überschreitung der maximalen Gradienteneigenschaft führt, wird vorteilhafterweise also keine weitere Überprüfung für andere Zeitpunkte durchgeführt. Vielmehr kann ein solcher Rotationswinkelwert gespeichert werden und nach Abschluss der Untersuchung als verboten markiert werden. Die Effizienz der Untersuchung kann dadurch also gesteigert werden.

Ferner wird eine Magnetresonanzvorrichtung vorgeschlagen, die ausgebildet ist, ein Verfahren zur Einstellung einer Sequenz einer Magnetresonanztomographie auszuführen. Vorzugsweise umfasst die Magnetresonanzvorrichtung eine Limitationsbereitstellungseinheit, die ausgebildet ist, zumindest eine Limitation bereitzustellen und eine Sequenzparameterbereitstellungseinheit, die ausgebildet ist, mehrerer Parameter einer Sequenz bereitzustellen. Die Magnetresonanzvorrichtung umfasst ferner vorzugsweise eine Auswahleinheit, insbesondere eine Eingabeeinheit, die ausgebildet ist, eine Auswahl eines der mehreren Parameter zu ermöglichen, und eine Simulationseinheit, die ausgebildet ist, zumindest einen Sequenzverlauf anhand des zumindest einen ausgewählten Parameters zu ermitteln. Darüber hinaus umfasst die Magnetresonanzvorrichtung vorzugsweise eine Auswerteeinheit, die ausgebildet ist, anhand des zumindest einen zeitlichen Sequenzverlaufs und der zumindest einen Limitation einen zulässigen Parameterwertebereich des ausgewählten Parameters zu ermitteln, und eine Festlegungseinheit, insbesondere eine Eingabeeinheit, die ausgebildet ist, eine Festlegung eines Parameterwertes innerhalb des zulässigen Parameterwertebereichs zu ermöglichen. Bevorzugt ist die Magnetresonanzvorrichtung ausgebildet, anhand des festgelegten Parameterwertes eine Messdatenaufnahme durchzuführen.

Die Vorteile der vorgeschlagenen Magnetresonanzvorrichtung entsprechen im Wesentlichen den Vorteilen des vorgeschlagenen Verfahrens zur Einstellung einer Sequenz einer Magnetresonanztomographie, welche vorab im Detail ausgeführt sind. Hierbei erwähnte Merkmale, Vorteile oder alternative Ausführungsformen können ebenso auch auf die anderen beanspruchten Gegenstände übertragen werden und umgekehrt.

Mit anderen Worten können die gegenständlichen Ansprüche auch mit den Merkmalen, die in Zusammenhang mit einem Verfahren beschrieben oder beansprucht sind, weitergebildet sein. Die entsprechenden funktionalen Merkmale des Verfahrens werden dabei durch entsprechende gegenständliche Module, insbesondere durch Hardware-Module, ausgebildet.

Zudem wird ein Computerprogrammprodukt vorgeschlagen, das ein Programm umfasst und direkt in einen Speicher einer programmierbaren Recheneinheit einer Magnetresonanzvorrichtung ladbar ist, mit Programmmitteln, um ein Verfahren zur Einstellung einer Sequenz einer Magnetresonanztomographie auszuführen, wenn das Programm in der Recheneinheit der Magnetresonanzvorrichtung ausgeführt wird.

Das Computerprogrammprogrammprodukt kann dabei eine Software mit einen Quellcode, der noch kompiliert und gebunden oder der nur interpretiert werden muss, oder einen ausführbaren Softwarecode umfassen, der zur Ausführung nur noch in den Speicher der Recheneinheit der Magnetresonanzvorrichtung zu laden ist. Durch das Computerprogrammprodukt kann das vorgeschlagene Verfahren schnell, identisch wiederholbar und robust ausgeführt werden. Das Computerprogrammprodukt ist so konfiguriert, dass es mittels der Recheneinheit die vorgeschlagenen Verfahrensschritte ausführen kann. Die Recheneinheit muss dabei jeweils die Voraussetzungen wie beispielsweise einen entsprechenden Arbeitsspeicher, eine entsprechende Grafikkarte oder eine entsprechende Logikeinheit aufweisen, so dass die jeweiligen Verfahrensschritte effizient ausgeführt werden können. Das Computerprogrammprodukt ist beispielsweise auf einem computerlesbaren Medium gespeichert oder auf einem Netzwerk oder Server hinterlegt, von wo es in einen Prozessor der Systemsteuereinheit geladen werden kann. Beispiele für computerlesbare Medien sind eine DVD, ein Magnetband oder einen USB-Stick, auf welchem elektronisch lesbare Steuerinformationen, insbesondere Software, gespeichert ist.

Weitere Vorteile, Merkmale und Einzelheiten der Erfindung ergeben sich aus den im Folgenden beschriebenen Ausführungsbeispielen sowie anhand der Zeichnungen. Einander entsprechende Teile sind in allen Figuren mit den gleichen Bezugszeichen versehen.

Es zeigen:

Fig. 1    eine Darstellung einer Magnetresonanzvorrichtung,

Fig. 2    eine exemplarische Blockdarstellung eines Verfahrens zur Einstellung einer Sequenz,

Fig. 3    ein k-Raum mit einem äußeren Bereich,

Fig. 4    drei exemplarische Sequenzverläufe,

Fig. 5    eine Prinzipskizze einer lückenlosen Suche,

Fig. 6    eine Prinzipskizze einer Binärsuche,

Fig. 7    eine Prinzipskizze eines absoluten und eines konservativen Parameterwertebereichs,

Fig. 8    weitere exemplarische Sequenzverläufe,

Fig. 9    weitere exemplarische Sequenzverläufe.

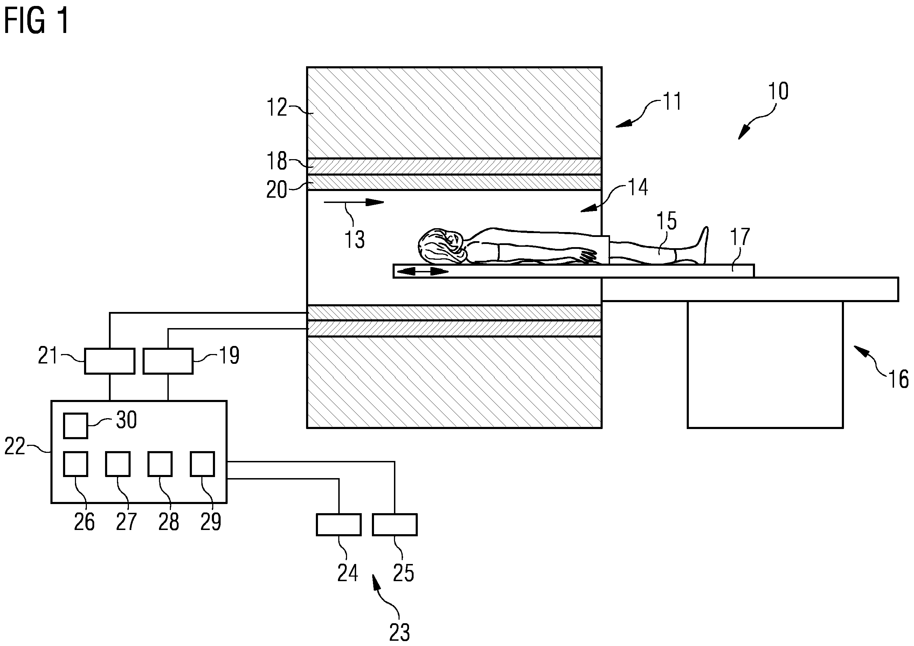

In Fig. 1 ist eine Magnetresonanzvorrichtung 10 schematisch dargestellt. Die Magnetresonanzvorrichtung 10 umfasst eine Magneteinheit 11, die einen supraleitenden Hauptmagneten 12 zu einem Erzeugen eines starken und insbesondere zeitlich konstanten Hauptmagnetfelds 13 aufweist. Zudem umfasst die Magnetresonanzvorrichtung 10 einen Patientenaufnahmebereich 14 zu einer Aufnahme eines Patienten 15. Der Patientenaufnahmebereich 14 im vorliegenden Ausführungsbeispiel ist zylinderförmig ausgebildet und in einer Umfangsrichtung von der Magneteinheit 11 zylinderförmig umgeben. Grundsätzlich ist jedoch eine davon abweichende Ausbildung des Patientenaufnahmebereichs 14 jederzeit denkbar. Der Patient 15 kann mittels einer Patientenlagerungsvorrichtung 16 der Magnetresonanzvorrichtung 10 in den Patientenaufnahmebereich 14 geschoben werden. Die Patientenlagerungsvorrichtung 16 weist hierzu einen innerhalb des Patientenaufnahmebereichs 14 bewegbar ausgestalteten Patiententisch 17 auf.

Die Magneteinheit 11 umfasst weiterhin eine Gradientenspuleneinheit 18 zu einer Erzeugung von Magnetfeldgradienten, die für eine Ortskodierung während einer Bildgebung verwendet werden und oftmals drei physikalische Gradientenachsen aufweist. Die Gradientenspuleneinheit 18 wird mittels einer Gradientensteuereinheit 19 der Magnetresonanzvorrichtung 10 gesteuert. Die Magneteinheit 11 umfasst weiterhin eine Hochfrequenzantenneneinheit 20, welche im vorliegenden Ausführungsbeispiel als fest in die Magnetresonanzvorrichtung 10 integrierte Körperspule ausgebildet ist. Die Hochfrequenzantenneneinheit 20 ist zu einer Anregung von Atomkernen, die sich in dem von dem Hauptmagneten 12 erzeugten Hauptmagnetfeld 13 einstellt, ausgelegt. Die Hochfrequenzantenneneinheit 20 wird von einer Hochfrequenzantennensteuereinheit 21 der Magnetresonanzvorrichtung 10 gesteuert und strahlt hochfrequente Magnetresonanzsequenzen in einen Untersuchungsraum ein, der im Wesentlichen von einem Patientenaufnahmebereich 14 der Magnetresonanzvorrichtung 10 gebildet ist. Die Hochfrequenzantenneneinheit 20 ist weiterhin zum Empfang von Magnetresonanzsignalen ausgebildet.

Zu einer Steuerung des Hauptmagneten 12, der Gradientensteuereinheit 19 und zur Steuerung der Hochfrequenzantennensteuereinheit 21 weist die Magnetresonanzvorrichtung 10 eine Systemsteuereinheit 22 auf. Die Systemsteuereinheit 22 steuert zentral die Magnetresonanzvorrichtung 10, wie beispielsweise das Durchführen einer vorbestimmten bildgebenden Sequenz wie z.B. eine Gradientenechosequenz und/oder eine Spinechosequenz. Zudem umfasst die Systemsteuereinheit 22 eine nicht näher dargestellte Rekonstruktionseinheit zu einer Erzeugung von einer oder mehreren Magnetresonanzabbildungen durch Rekonstruktion von Magnetresonanzsignalen, die während der Magnetresonanzuntersuchung erfasst werden. Des Weiteren umfasst die Magnetresonanzvorrichtung 10 eine Benutzerschnittstelle 23, die mit der Systemsteuereinheit 22 verbunden ist. Steuerinformationen wie beispielsweise Bildgebungsparameter, sowie rekonstruierte Magnetresonanzabbildungen können auf einer Anzeigeeinheit 24, beispielsweise auf zumindest einem Monitor, der Benutzerschnittstelle 23 für ein medizinisches Bedienpersonal angezeigt werden. Weiterhin weist die Benutzerschnittstelle 23 eine Eingabeeinheit 25 auf, mittels der Informationen und/oder Parameter während eines Messvorgangs von dem medizinischen Bedienpersonal eingegeben werden können.

Um ein erfindungsgemäßes Verfahren zur Einstellung einer Sequenz einer Magnetresonanztomographie auszuführen, umfasst die Magnetresonanzvorrichtung 10, hier insbesondere die Systemsteuereinheit 22, eine Limitationsbereitstellungseinheit 26, die ausgebildet ist, zumindest eine Limitation bereitzustellen, und eine Sequenzparameterbereitstellungseinheit 27, die ausgebildet ist, mehrerer Parameter einer Sequenz bereitzustellen. Mittels der Eingabeeinheit 25, die in diesem Ausführungsbeispiel von einer hier nicht dargestellten Auswahleinheit umfasst wird, kann einer der mehreren Parameter ausgewählt werden. Aber auch eine automatische Auswahl ist denkbar. Zudem umfasst die Magnetresonanzvorrichtung 10 eine Simulationseinheit 28, die ausgebildet ist, zumindest einen Sequenzverlauf anhand des zumindest einen ausgewählten Parameters zu ermitteln, und eine Auswerteeinheit 29, die ausgebildet ist, anhand des zumindest einen zeitlichen Sequenzverlaufs und der zumindest einen Limitation einen zulässigen Parameterwertebereich des ausgewählten Parameters zu ermitteln. Dabei ist die Eingabeeinheit 25 ferner ausgebildet, eine Festlegung eines Parameterwertes innerhalb des zulässigen Parameterwertebereichs zu ermöglichen. Die Eingabeeinheit wird in diesem Ausführungsbeispiel von einer hier nicht dargestellten Festlegungseinheit umfasst. Mit der Magnetresonanzvorrichtung 10 kann anhand des festgelegten Parameterwertes eine Messdatenaufnahme durchgeführt werden.

Insbesondere umfasst die Systemsteuereinheit 22 eine programmierbare Recheneinheit 30, das einen hier nicht näher dargestellten Speicher aufweist, in welches ein Computerprogrammprodukt ladbar ist. Das Computerprogrammprodukt umfasst Programmmittel, um ein Verfahren zur Einstellung einer Sequenz einer Magnetresonanztomographie auszuführen, wenn das Programm in der Recheneinheit 30 der Magnetresonanzvorrichtung 10 ausgeführt wird.

Die dargestellte Magnetresonanzvorrichtung 10 im vorliegenden Ausführungsbeispiel kann selbstverständlich weitere Komponenten umfassen, die Magnetresonanzvorrichtungen gewöhnlich aufweisen. Eine allgemeine Funktionsweise einer Magnetresonanzvorrichtung 10 ist zudem dem Fachmann bekannt, so dass auf eine detaillierte Beschreibung der allgemeinen Komponenten verzichtet wird.

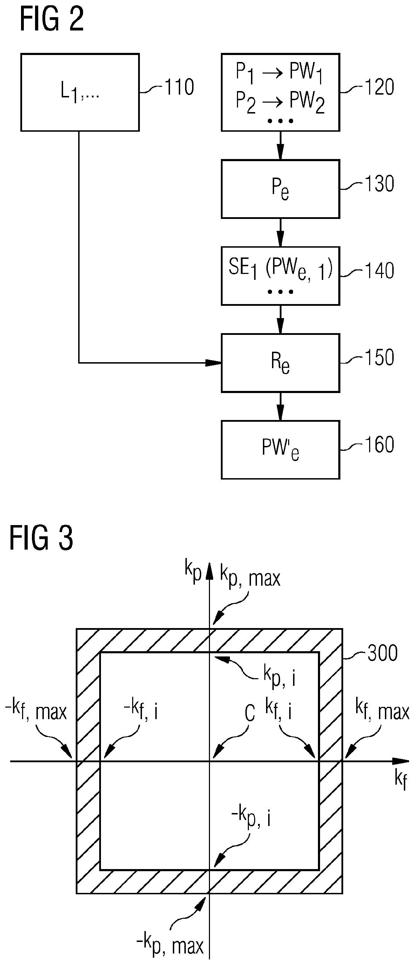

In Fig. 2 ist ein Blockdiagramm einer Ausführungsform des erfindungsgemäßen Verfahrens dargestellt. In einem Schritt 110 wird eine Limitation $L_1$ durch eine Limitationsbereitstellungseinheit 26 bereitgestellt, wobei auch noch zusätzliche Limitationen $L_2$, $L_3$, etc. denkbar sind.

In einem Schritt 120 werden mehrere, hier zwei, Parameter $P_1$, $P_2$ einer Sequenz durch eine Parameterbereitstellungseinheit 27 bereitgestellt, wobei auch noch zusätzliche Parameter $P_3$, $P_4$, etc. denkbar sind. Dem Parameter $P_1$ ist ein voreingestellter Parameterwert $PW_1$ und dem Parameter $P_2$ ein voreingestellter Parameterwert $PW_2$ zugeordnet.

In einem Schritt 130 wird aus den mehreren Parametern $P_1$ und $P_2$ ein Parameter ausgewählt, z.B. $P_2$. Diese Auswahl erfolgt beispielsweise durch einen Bediener, der dazu die Eingabeeinheit 25 verwendet. Dem Benutzer können bei der Auswahl alle oder ein Teil der Parameter $P_1$, $P_2$ angeboten werden, beispielsweise durch eine Anzeige mittels der Anzeigeeinheit 24.

Anhand der voreingestellten Parameterwerte $PW_1$, $PW_2$ wird in Schritt 140 durch eine Simulationseinheit 28 zumindest ein Signalverlauf ermittelt. In diesem Beispiel wird ein Signalverlauf $SE_1$ für einen Testparameterwert $PW_{e,1}$ ermittelt. Es können auch noch weitere Signalverläufe $SE_2$, $SE_3$, etc. für weitere Testparameterwerte $PW_{e,1}$, $PW_{e,3}$ ermittelt werden. Die Testparameterwerte $PW_{e,1}$, $PW_{e,2}$, $PW_{e,3}$ sind dabei vorzugsweise dem ausgewählten Parameter $P_e$ zugeordnete Werte.

Unter der Ermittlung des zumindest einen Signalverlaufs $SE_1$ kann ein zeitliches Ausrollen zumindest eines Teilabschnitt der Sequenz verstanden werden. Vorteilhafterweise ist der zumindest eine Teilabschnitt repräsentativ für die gesamte Sequenz. Beim Ausrollen wird beispielsweise der zumindest eine Teilabschnitt der Sequenz in mehrere Zeitpunkte eingeteilt, für die jeweils ein Verlaufswert berechnet wird.

Insbesondere können dabei Gradientenverläufe ausgerollt werden. Es ist denkbar, dass dabei die Gradientenverläufe so dargestellt werden, sie schließlich von der Hardware der Magnetresonanzvorrichtung tatsächlich ausgeführt werden, z.B. indem Wirbelstromkompensation oder ähnliches berücksichtigt wird.

In Schritt 150 wird durch eine Auswerteeinheit 29 anhand des zumindest einen Sequenzverlaufs $SE_1$ und der zumindest einen Limitation $L_1$ ein zulässiger Parameterwertebereich $R_e$ des ausgewählten Parameters $P_e$ ermittelt. Dabei umfasst die Ermittlung eines zulässigen Parameterwertebereichs $R_e$ des ausgewählten Parameters anhand des zumindest einen Sequenzverlaufs und der zumindest einen Limitation $L_1$ durch eine Auswerteinheit wenigstens eine der folgenden Iteration. Im Rahmen jeder Iteration wird eine Simulation der Durchführung des Sequenzverlaufs der Magnetresonanztomographie mit dem voreingestellten Parameterwert. Sofern bei der Simulation alle Limitationen eingehalten werden, wird die aktuelle Iteration abgebrochen. Wenn nicht, wird die Art des Nichteinhaltens der zumindest einen Limitation $L_1$ bestimmt und basierend auf der Art des Nichteinhaltens der voreingestellte Parameterwert für eine nachfolgende Iteration geändert.

Die Ermittlung des zulässigen Parameterwertebereichs $R_e$ kann eine Untersuchung des zumindest einen Sequenzverlaufs $SE_1$ umfassen. Bevorzugt wird dabei zur Feststellung eines zulässigen Parameterwerts jeder der Zeitpunkte des Sequenzverlaufs hinsichtlich der zumindest einen Limitationen $L_1$ untersucht. Bei der Untersuchung können beispielsweise Gradienteneigenschaften, wie Gradientenamplitude und/oder Gradientenanstiegsrate, auf den einzelnen Gradientenachsen, eine erwartete Erwärmung, z.B. anhand von gemittelten Gradientenamplituden, und/oder eine erzeugte Stimulation ausgewertet werden.

Ferner ist es denkbar, dass der untersuchte Signalverlauf vorteilhaft in verschiedene Unterbereiche unterteilt wird, die von der Simulationseinheit einzeln betrachtet werden, so dass für jeden Unterbereich eine unabhängige Analyse durchgeführt wird.

Das Ausrollen und die Untersuchung des zumindest einen Sequenzverlauf $SE_1$ wird vorteilhafterweise durchgeführt, während der Bediener eine Messung parametriert. In einer Ausführungsform passt sich der dem Bediener zur Verfügung stehende Parameterbereich $R_e$, der auch als Parameterraum bezeichnet werden kann, beim Wählen der Parameter in einer Benutzerschnittstelle 23 anhand der Ergebnisse der Untersuchung an.

Der Bediener kann in Schritt 160 einen neuen Parameterwert $PW'_e$ des ausgewählten Parameters $P_e$ festlegen. Dabei liegt der neue Parameterwert $PW'_e$ vorteilhafterweise innerhalb des zulässigen Parameterwertebereich $R_e$. Der neue Parameterwert $PW'_e$ kann alternativ auch automatisch gewählt werden.

Als Ausführungsbeispiel sei eine zweidimensionale Gradientenechosequenz genannt mit T1-Kontrast genannt. Bei einer Stärke des Hauptmagnetfelds 13 von drei Tesla wird z.B. eine Echozeit 2,3 ms benötigt, wodurch die mögliche Auflösung und/oder Bandbreite begrenzt werden. Würden von vornherein nur beispielsweise 50% einer eigentlich möglichen Gradientenamplitude auf den physikalischen Gradientenachsen zugelassen, um etwa etwaige ungünstige Parameterkonstellationen von vornherein auszuschließen, so dass die Sequenz auch bei einer ungünstigen Orientierung einer Messschicht durchführbar ist, ergäbe sich eine Bandbreite von z.B. 380 Hz pro Pixel.

Eine ungünstige Orientierung kann sich beispielsweise ergeben, wenn sich alle Gradientenobjekte logischer Gradientenachsen zwischen einer Anregung und einer Akquisition von Magnetresonanzsignalen auf einer physikalischen Gradientenachse treffen. Oftmals ist dieser Fall jedoch nicht gegeben, da die Rotation einer MRT-Abbildung in vielen Fällen nur leicht von den physikalischen Gradientenachsen abweicht. Daher wird die individuell gewünschte Rotation berücksichtigt, die in diesem Beispiel durch einen oder mehrere der bereits voreingestellten Parameterwerte repräsentiert wird, die in Schritt 120 bereitgestellt werden. In Schritt 130 wird die Bandbreite ausgewählt, worauf in Schritt 140 Sequenzverläufe, insbesondere Gradientenverläufe zumindest eines repräsentativen Abschnitts ermittelt werden. Ein repräsentativer Abschnitt kann vorteilhafterweise äußere k-Raumlinien umfassen, die beispielhaft in Fig. 3 dargestellt werden. Ein erfasster k-Raum wird hier auf einer Phasenkodierachse $k_p$ durch $-k_{p,max}$ und $k_{p,max}$ und auf einer Frequenzkodierachse $k_f$ durch $-k_{f,max}$ und $k_{f,max}$ begrenzt. Die äußeren k-Raumlinien liegen dabei in einem äußeren Bereich 300 des erfassten k-Raums, wobei der äußere Bereich 300 in Richtung eines Zentrums C des k-Raums auf einer Phasenkodierachse $k_p$ durch $-k_{p,i}$ und $k_{p,i}$ und auf einer Frequenzkodierachse $k_f$ durch $-k_{f,i}$ und $k_{f,i}$ begrenzt wird. Der äußere Bereich 300 ist von einem Zentrum C des k-Raums vorzugsweise um mindestens 70%, d.h. $k_{p,i}/k_{p,max} \geq 70\%$, bevorzugt mindestens 80%, d.h. $k_{p,i}/k_{p,max} \geq 80\%$, besonders bevorzugt mindestens 90%, d.h. $k_{p,i}/k_{p,max} \geq 90\%$, des erfassten k-Raums beabstandet. Vorteilhafterweise verwenden die k-Raumlinien in diesem äußeren Bereich die höchsten Gradientenamplituden. Die Ermittlung des zumindest einen Sequenzverlaufs in Schritt 140 kann beispielsweise gestartet werden, sobald ein Bediener in ein Feld klickt, das mit "Bandbreite" betitelt ist.

Der zumindest eine Sequenzverlauf wird hinsichtlich der zumindest einen Limitation untersucht. Die Untersuchung kann mehrere Teiluntersuchungen umfassen, wobei bei jeder Teiluntersuchung jeweils eine der zumindest einen Limitation untersucht wird. Die Teiluntersuchungen können in einer Reihenfolge absteigender Priorität ausgeführt werden, so dass Teiluntersuchungen mit geringerer Priorität nur ausgeführt werden, wenn die mit höherer Priorität positiv verlaufen. Eine denkbare Priorisierung wäre: 1. Gradientenamplitude, 2. Gradientenanstiegsrate, 3. Stimulation, 4. Erwärmung.

Aus der Untersuchung könnte sich beispielsweise ergeben, dass sich für die Bandbreite bei voller Auslastung der Gradientenspuleneinheit 18 eine minimale Bandbreite von 240 Hz pro Pixel ergeben würde. Allerdings würde dabei z.B. eine Stimulationsgrenze überschritten, so dass der in Schritt 150 ermittelte zulässige Parameterwertebereich $R_e$ beispielsweise durch eine minimale Bandbreite von 265 Hz begrenzt wird. In Schritt 160 kann die Bandbreite beispielsweise auf die minimale Bandbreite von 265 Hz festgelegt werden. Eine Reduzierung von ursprünglich 380 auf 265 Hz pro Pixel entspräche einer Erhöhung eines Signalrauschverhältnisses der Magnetresonanzsignale von 20%.

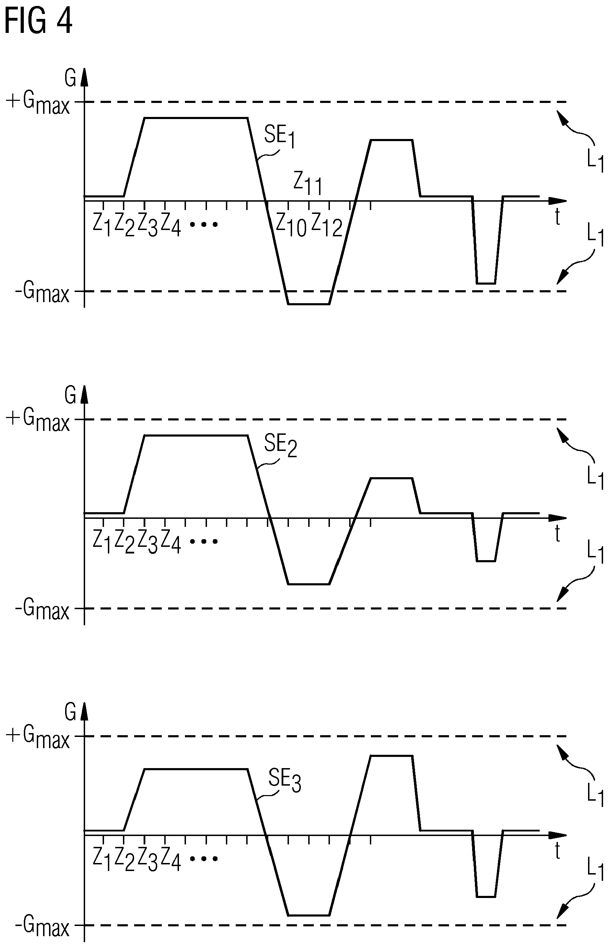

In Fig. 4 sind beispielhaft drei ermittelte Sequenzverläufe $SE_1$, $SE_2$, $SE_3$ gezeigt. Die Sequenzverläufe sind in diesem Beispiel Verläufe einer Gradientenamplitude G über die Zeit t. Jedem der Sequenzverläufe $SE_1$, $SE_2$, $SE_3$ ist dabei in anderer Testparameterwert eines gewählten Parameters $P_e$, z.B. einem Rotationswinkelparameter, zugrunde gelegt, d.h. anhand eines ersten Testparameterwerts $PW_{e,1}$ wird ein erster Sequenzverlauf $SE_1$ ermittelt, anhand eines zweiten Testparameterwerts $PW_{e,2}$ wird ein zweiter Sequenzverlauf $SE_2$ ermittelt und anhand eines dritten Testparameterwerts $PW_{e,3}$ wird ein dritter Sequenzverlauf $SE_3$ ermittelt.

Zur Ermittlung des zulässigen Parameterwertebereich werden die jeweiligen Sequenzverläufe $SE_1$, $SE_2$, $SE_3$ dahingehend untersucht, ob sie die zumindest eine Limitation $L_1$ erfüllen, die in diesem Beispiel durch eine Einhaltung einer maximalen Gradientenamplitude $G_{max}$ gegeben ist, d.h. der Betrag der Gradientenamplitude soll hier kleiner oder gleich $G_{max}$ sein.

Die Sequenzverläufe weisen mehrere Zeitpunkte $Z_1$, $Z_2$, $Z_3$, $Z_4$, etc. auf. Diese Limitation $L_1$ wird vorzugsweise für jeden dieser mehreren Zeitpunkte überprüft. Für dieses Beispiel ergäbe sich, dass der Gradientenverlauf $SE_1$ in den Zeitpunkten $Z_{10}$, $Z_{11}$ und $Z_{12}$ die Limitation $L_1$ verletzt, d.h. der Betrag der Gradientenamplitude ist größer als die maximale Gradientenamplitude $G_{max}$. Daraus ergibt sich hier, dass der Testparameterwerts $PW_{e,1}$, anhand dessen der erster Sequenzverlauf $SE_1$ ausgerollt wurde, kein zulässiger Parameterwert eines gewählten Parameters $P_e$ ist. Der zulässige Parameterbereich $R_e$ enthält in diesem Beispiel also nur die $PW_{e,2}$ und $PW_{e,3}$. Der Bediener kann in Schritt 160 aus diesem Parameterbereich $R_e$ also beispielsweise den Parameter $PW_{e,2}$ als neuen Parameterwert $PW'_e$ auswählen.

Die Ermittlung des zulässigen Parameterwertebereichs kann beispielsweise mit Hilfe einer lückenlosen Suche und/oder einer Binärsuche durchgeführt werden.

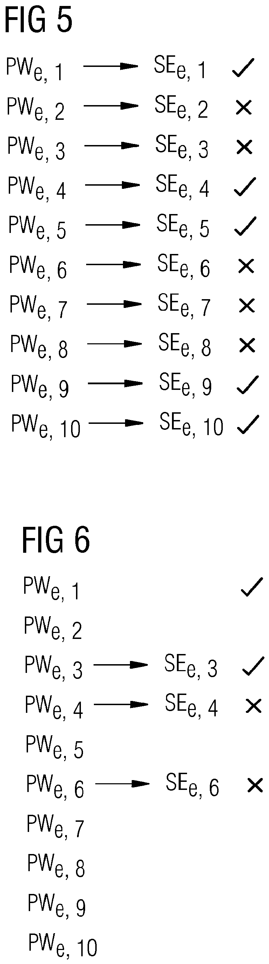

Bei einer lückenlosen Suche wird in der Regel für jeden zu untersuchenden Testparameterwert $PW_{e,x}$, x=1, ... in Schritt 140 ein Signalverlauf $SE_{1,x}$, x=1, ... ermittelt, wobei in Schritt 150 jeder ermittelte Signalverlauf hinsichtlich der zumindest einen Limitation überprüft wird. In Fig. 5 wird dies beispielhaft demonstriert: Hier sollen zehn Testparameterwerte $PW_{e,1}$, ..., $PW_{e,10}$ untersucht werden. Für jeden dieser zehn Testparameterwerte wird in Schritt 140 ein Signalverlauf $SE_{e,1}$, ..., $SE_{e,10}$ ermittelt. Aus der Untersuchung in Schritt 150 ergibt sich beispielsweise, dass die Signalverläufe $SE_{e,1}$, $SE_{e,4}$, $SE_{e,5}$, $SE_{e,9}$, $SE_{e,10}$ die zumindest eine Limitierung erfüllen und dementsprechend die Signalverläufe $SE_{e,2}$, $SE_{e,3}$, $SE_{e,6}$, $SE_{e,7}$, $SE_{e,8}$ nicht. Der zulässige Parameterbereich $R_e$ umfasst also die Testparameterwerte $PW_{e,1}$, $PW_{e,4}$, $PW_{e,5}$, $PW_{e,9}$, $PW_{e,10}$. Dies wird in Fig. 5 mit Hilfe von Haken illustriert, wohingegen die nicht-zulässigen Parameterwerte mit einem Kreuzchen versehen sind.

Insbesondere falls die Testparameterwerte $PW_{e,1}$, ..., $PW_{e,10}$ sortiert sind, also beispielsweise $PW_{e,1} < PW_{e,2}$, $PW_{e,2} < PW_{e,3}$, ..., $PW_{e,9} < PW_{e,10}$ gilt, umfasst der zulässige Parameterbereich $P_e$ eine nicht-konvexe Menge, da die gültigen $SE_{e,1}$, $SE_{e,4}$, $SE_{e,5}$, $SE_{e,9}$, $SE_{e,10}$ Lücken aufweisen. Für Testparameterwerte, für die sich ein nicht-konvexer Parameterbereich $P_e$ ergeben kann, ist folglich eine lückenlose Suche besonders geeignet, da somit zuverlässig alle zulässigen Parameterwerte gefunden werden können.

Dagegen eignet sich eine Binärsuche insbesondere bei Testparameterwerten, für die sich üblicherweise ein konvexer Parameterbereich $P_e$ ergibt. Dies soll für das in Fig. 6 dargestellte Beispiel gelten, bei dem wieder zehn Testparameterwerte $PW_{e,1}$, ..., $PW_{e,10}$ gegeben sind. Die Testparameterwerte weisen einen ersten Startparameterwert und einen zweiten Startparameterwert auf, die üblicherweise die äußeren und/oder die Extrema der Testparameterwerte darstellen. Somit kann beispielsweise der Testparameterwert $PW_{e,1}$ als erster und der Testparameterwert $PW_{e,10}$ als zweiter Startparameterwert betrachtet werden. Die Startparameterwerte können möglicherweise aus der zumindest einen Limitation abgeleitet werden.

Ferner sei hier vorteilhafterweise bekannt, dass für den erste Startparameterwert die zumindest eine Limitation erfüllt ist. Daher kann für diesen Startparameterwert auf die Ermittlung eines Signalverlaufs verzichtet werden.

Bezugnehmend auf das oben ausgeführte Beispiel, das eine Festlegung einer Bandbreite beschreibt, kann als erster Startparameterwert ein Bandbreitenwert von 380 Hz pro Pixel verwendet werden.

Bei der Binärsuche wird vorteilhafterweise zunächst für einen mittigen Testparameterwert zwischen dem ersten und dem zweiten Startparameterwert eine Untersuchung durchgeführt. Bei einer geraden Anzahl an zu untersuchenden Testparameterwerten existiert in der Regel kein Testparameterwert, der die Menge der Testparameterwerte in zwei exakte gleich große Teilmengen teilt. Daher kann ein mittiger Parameterwert eine Menge an zu untersuchenden Testparameterwerten auch in zwei Teilmengen teilen, deren Anzahlen an Testparameterwerten sich um eins unterscheiden.

In diesem Fall wird also beispielsweise zunächst der Testparameterwert $PW_{e,6}$ untersucht, d.h. es wird ein entsprechender Signalverlauf $SE_{e,6}$ ermittelt, der hinsichtlich der zumindest einen Limitation untersucht wird. Beispielhaft soll dabei angenommen werden, dass sich aus dieser Untersuchung ergibt, dass die zumindest eine Limitation nicht erfüllt wird. Dann wird die neue nun zu untersuchende Menge an Testparameterwerten, die nun durch $PW_{e,1}$ und $PW_{e,6}$ eingegrenzt wird, durch einen neuen mittigen Testparameterwerten $PW_{e,3}$ geteilt. Nach diesem Prinzip wird bei der Binärsuche die Menge zu untersuchenden Testparameterwerten schrittweise halbiert, so dass in diesem Beispiel nur die Ermittlung von drei Signalverläufen $SE_{e,3}$, $SE_{e,4}$ und $SE_{e,6}$ notwendig ist, um den zulässigen Parameterwertebereich $P_e$ zu bestimmen, der hier die Parameterwerte $PW_{e,1}$, $PW_{e,2}$ und $PW_{e,3}$ umfasst. Eine Binärsuche ist also für Testparameterwerte, für die sich üblicherweise ein konvexer Parameterbereich $P_e$ ergibt, eine besonders effiziente Variante.

Sowohl bei der lückenlosen Suche gem. Fig. 5 als auch bei der Binärsuche gem. Fig. 6 ist es denkbar, dass alle Testparameterwerte $PW_{e,1}$,...,$PW_{e,10}$ gültig sind. In diesem Fall kann der zu untersuchende Bereich erweitert werden, d.h. es kann eine weitere Suche durchgeführt werden, die Testparameterwerte umfasst, die beispielsweise größer als $PW_{e,10}$ sind.

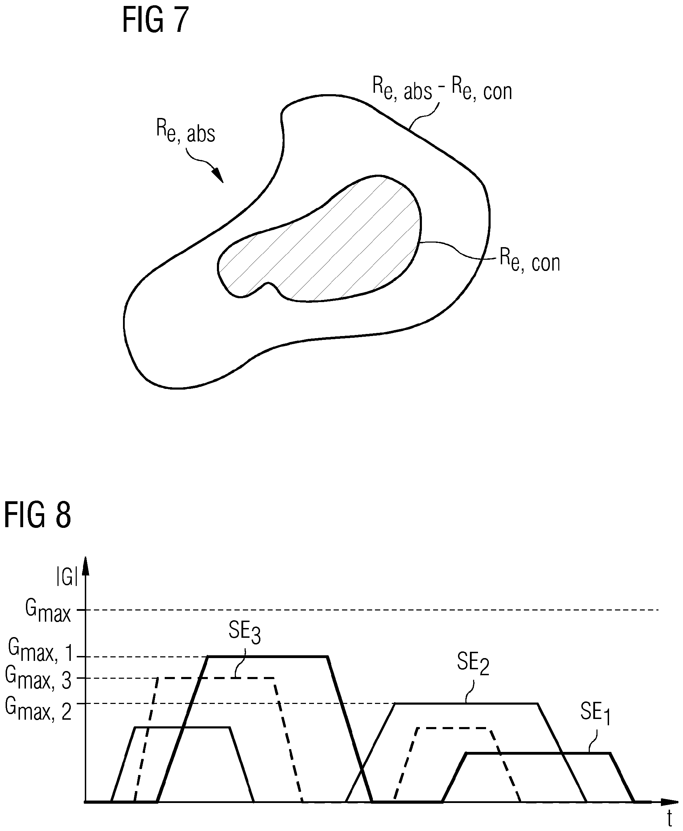

Die zumindest eine Limitation kann insbesondere zumindest eine absolute Limitation und zumindest eine konservative Limitation umfassen. Dabei können die zumindest absolute Limitation einen absoluten Parameterwertebereich $R_{e,abs}$ und die zumindest eine konservative Limitation einen konservativen Parameterwertebereich $R_{e,con}$ festlegen, wie in Fig. 7 illustriert wird. In zumindest einem Differenzbereich $R_{e,abs}$-$R_{e,con}$ von absolutem Parameterwertebereich $R_{e,abs}$ und konservativen Parameterwertebereich $R_{e,con}$ kann zumindest ein zulässiger Teilparameterwertebereich ermittelt werden, wobei der zulässige Parameterwertebereich den konservativen Parameterwertebereich und den zulässigen Teilparameterwertebereich umfasst. Dadurch verkleinert sich der untersuchende Parameterwertebereich, so dass das Verfahren beschleunigt werden kann.

Eine weitere Ausführungsform wird in Fig. 8 näher illustriert. Hier umfasst die zumindest eine Limitation eine maximale Gradienteneigenschaft für eine physikalische Gradientenachse, hier beispielhaft eine maximale Gradientenamplitude $G_{max}$. Ferner werden drei Gradientenverläufe $SE_1$, $SE_2$ und $SE_3$ exemplarisch als Sequenzverläufe dargestellt, wobei die Gradientenverläufe einen zeitlichen Verlauf eines Betrags einer Gradientenamplitude $|G|$ für jeweils eine physikalische Gradientenachse repräsentieren, beispielsweise $SE_1$ für eine x-Achse, $SE_2$ für eine y-Achse und $SE_3$ für eine z-Achse. Jeder Gradientenverlauf weist zumindest ein Maximum $G_{max,1}$, $G_{max,2}$, $G_{max,3}$ auf, das beispielsweise für den Gradientenverlauf $SE_1$ mit $G_{max,1}$=max($SE_1$) beschrieben werden kann.

Aus dem Verlauf kann ein Gradientenoptimierungswert K ermittelt werden, indem für jeden Signalverlauf $SE_1$, $SE_2$ und $SE_3$ ein Verhältnis V aus der maximalen Gradientenamplitude $G_{max}$ zu einem Maximum des Signalverlaufs $G_{max,1}$, $G_{max,2}$, $G_{max,3}$ ermittelt wird, so dass sich für dieses Beispiel $V_1$=$G_{max}$/$G_{max,1}$=4/3, $V_2$=$G_{max}$/$G_{max,2}$=2 und $V_3$=$G_{max}$/$G_{max,3}$=8/5 ergibt. Der Gradientenoptimierungswert K ist vorzugsweise das Minimum der berechneten Verhältnisse, d.h. in diesem Fall K=min($V_1$;$V_2$;$V_3$)=4/3.

Die Gradientenverläufe können also bis um den Faktor K angehoben werden, ohne die maximale Gradientenamplitude zu überschreiten. Durch eine derartige Anhebung können oftmals Gradientenpulse unter Beibehaltung ihres Gradientenmoments verkürzt werden, so dass daraus eine Beschleunigung der Magnetresonanztomographie resultiert.

Eine Verkippung der die Koordinatensysteme von physikalischen und logischen Gradientenachsen kann mit Hilfe von Rotationsmatrizen beschrieben werden. Beispielsweise lautet bei einer Rotation um einen Winkel θ um die x-Achse eine entsprechende Rotationsmatrix:

$$R_x(\theta) = \begin{bmatrix} 1 & 0 & 0 \\ 0 & \cos(\theta) & -\sin(\theta) \\ 0 & \sin(\theta) & \cos(\theta) \end{bmatrix}$$

Analoges gilt für die y- und die z-Achse. Anhand einer solchen Rotationsmatrix folgt mit einer Matrixgleichung $G_{phys}=RG_{log}$, welchen Anteil welcher logischer Gradient auf welcher physikalischen Gradientenachse hat. Beispielsweise kann die zu einem Zeitpunkt auf der x-Achse benötigte Gradientenamplitude Beiträge aller logischen Gradientenachsen umfassen.

Stimmen die Koordinatensysteme der physikalischen Gradientenachsen und der logischen Gradientenachsen überein, kann die Untersuchung in gleicher Weise auch anhand der Gradientenverläufe der logischen Gradientenachsen durchgeführt werden. Anderenfalls kann anhand der Invertierten der oben erläuterten Rotationsmatrizen die Anteile der logischen Gradientenachsen auf den physikalischen Gradientenachsen berücksichtigt werden. Dabei kann z.B. festgestellt werden, dass ein Phasenkodiergradient $G_p$ auf der x-Achse um einen Faktor 2, auf der y-Achse um 1,5 und auf z um 3 größer sein dürfte. Analoge Betrachtungen können für einen Frequenzkodiergradienten $G_f$ und eine Schichtselektionsgradienten $G_s$ angestellt werden. Von diesen Werten wird vorzugsweise ein Minimum verwendet, um für jede logische Gradientenachse eine maximale Gradientenamplitude zu erreichen.

Analog kann auch bei anderen Gradienteneigenschaften vorgegangen werden, wie beispielsweise einer Gradientenanstiegsrate und/oder einer Stimulation, wobei dazu vorteilhafterweise eine zeitliche Ableitung der Gradientenamplitude und/oder bei eine Untersuchung eines Zeitpunkts $Z_i$ auch ein vorangehender Zeitpunkt $Z_{i-1}$ und/oder ein nachfolgender Zeitpunkt $Z_{i+1}$ berücksichtigt wird.

Parametermeterbereiche von Parametern, die von den Gradienteneigenschaften abhängig sind, wozu natürlich Parametermeterbereiche der Gradienteneigenschaften selbst gehören können, können auf diese Weise effizient ermittelt werden, da nur wenige, wie in diesem Beispiel drei, Sequenzverläufe untersucht werden müssen.

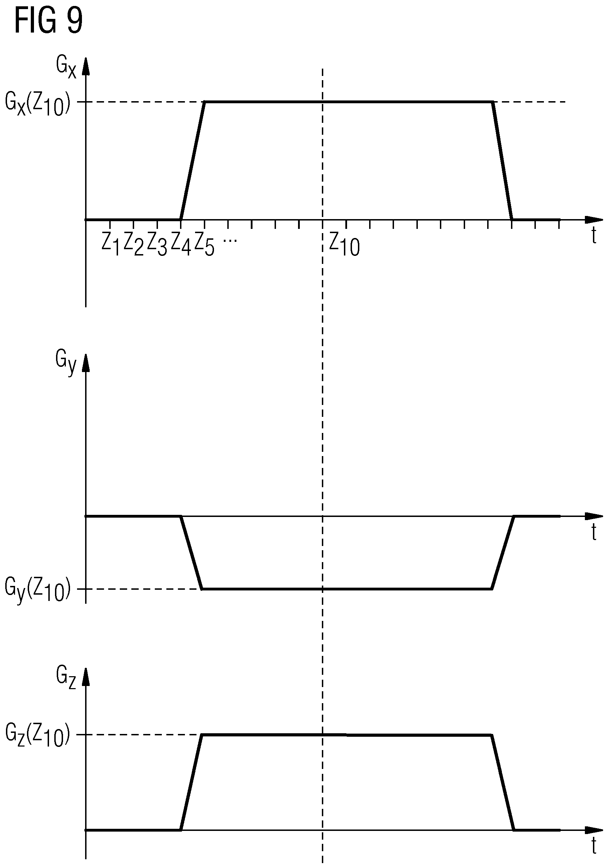

Ein weiterer Aspekt der Erfindung wird in Fig. 9 illustriert, der besonders vorteilhaft ist, falls der in Schritt 130 ausgewählte Parameter $P_e$ von einem Rotationswinkelparameter $P_r$ abhängig ist, d.h. $P_e(P_r)$. Dies ist insbesondere dann der Fall, wenn ein Rotationswinkelparameter selbst ausgewählt wurde, d.h. $P_e=P_r$, und die zumindest eine Limitation zumindest eine maximale Gradienteneigenschaft für zumindest eine physikalische Gradientenachse umfasst. Üblicherweise weist die Gradientenspuleneinheit 18 der Magnetresonanzvorrichtung 10 drei physikalische Gradientenachsen aufweist, z.B. eine x-Achse, eine y-Achse und eine z-Achse, was auch für dieses Beispiel angenommen werden soll. Ferner sei hier angenommen, dass die maximale Gradienteneigenschaft für alle drei physikalische Gradientenachsen gleich ist, z.B. eine gleich große Gradientenamplitude $G_{max}=G_{max,x}=G_{max,y}=G_{max,z}$. In Fig. 9 sind beispielhaft in Schritt 140 ermittelte Gradientenverläufe für einen Gradientenpuls über die Zeit t dargestellt. Dieser Gradientenverlauf umfasst mehrere Zeitpunkte $Z_1,Z_2,....$ Für zumindest einen der mehreren Zeitpunkte $Z_1,Z_2,...$ wird vorteilhafterweise eine euklidische Summe der Gradienteneigenschaft ermittelt. Dieser Schritt soll exemplarisch für den Zeitpunkt $Z_{10}$ durchgeführt werden. Zu diesem Zeitpunkt weist eine Gradientenamplitude $G_x$ auf der x-Achse einen Wert $G_x(Z_{10})$ auf, eine Gradientenamplitude $G_y$ auf der y-Achse einen Wert $G_y(Z_{10})$ auf und eine Gradientenamplitude $G_z$ auf der z-Achse einen Wert $G_z(Z_{10})$. Die euklidische Summe $G_{es}$ zum Zeitpunkt $Z_{10}$ wird hier mit $G_{es}=(G_x(Z_{10})^2+G_y(Z_{10})^2+G_z(Z_{10})^2)^{0,5}$ ermittelt. $G_{es}$ wird dann vorteilhafterweise mit der zumindest einen maximalen Gradienteneigenschaft, hier also $G_{max}$, verglichen. Falls für jeden Zeitpunkt der Gradientenverläufe $G_{es}≤G_{max}$ gilt, kann der Rotationswinkel beliebig verändert werden, ohne die maximale Gradienteneigenschaft $G_{max}$ zu verletzen.

Auf diese Weise können die Zeitpunkte der Gradientenverläufe nacheinander untersucht werden. Sobald bei einem Zeitpunkt der Vergleich der euklidische Summe der Gradienteneigenschaft mit der zumindest einen maximalen Gradienteneigenschaft ergibt, dass die zumindest eine maximale Gradienteneigenschaft verletzt, insbesondere überschritten wird, kann zumindest ein zulässiger Rotationswinkel mit Hilfe einer lückenlosen Suche ermittelt werden, wie vorab bereits erläutert wurde .

Es wird abschließend noch einmal darauf hingewiesen, dass es sich bei den vorhergehend detailliert beschriebenen Verfahren sowie bei der dargestellten Magnetresonanzvorrichtung lediglich um Ausführungsbeispiele handelt, welche vom Fachmann in verschiedenster Weise modifiziert werden können, ohne den Bereich der Erfindung zu verlassen. Weiterhin schließt die Verwendung der unbestimmten Artikel "ein" bzw. "eine" nicht aus, dass die betreffenden Merkmale auch mehrfach vorhanden sein können. Ebenso schließen die Begriff "Einheit" und "Modul" nicht aus, dass die betreffenden Komponenten aus mehreren zusammenwirkenden Teil-Komponenten bestehen, die gegebenenfalls auch räumlich verteilt sein können.

**Patentansprüche**

1.  Verfahren zur Einstellung einer Sequenz einer Magnetresonanztomographie umfassend folgende Schritte:

a) Bereitstellen zumindest einer Limitation durch eine Limitationsbereitstellungseinheit,

b) Bereitstellen mehrerer Parameter der Sequenz durch eine Parameterbereitstellungseinheit,

wobei zumindest einem der mehreren Parameter ein voreingestellter Parameterwert zugeordnet ist,

c) Auswahl eines der mehreren Parameter mittels einer Auswahleinheit,

d) Ermittlung zumindest eines Sequenzverlaufs durch eine Simulationseinheit anhand von zumindest einem der voreingestellten Parameterwerte,

e) Ermittlung eines zulässigen Parameterwertebereichs des ausgewählten Parameters anhand des zumindest einen Sequenzverlaufs und der zumindest einen Limitation durch eine Auswerteeinheit,

f) Festlegung eines neuen Parameterwertes des ausgewählten Parameters innerhalb des zulässigen Parameterwertebereichs mittels einer Festlegungseinheit,

**dadurch gekennzeichnet,**

**dass** die Ermittlung eines zulässigen Parameterwertebereichs des ausgewählten Parameters anhand des zumindest einen Sequenzverlaufs und der zumindest einen Limitation durch eine Auswerteeinheit wenigstens eine Iteration umfasst, wobei die Iteration umfasst:

Simulation der Durchführung des Sequenzverlaufs der Magnetresonanztomographie mit dem voreingestellten Parameterwert;

Abbruch der aktuellen Iteration, wenn bei der Simulation die Limitationen eingehalten werden;

Feststellung der Art des Nichteinhaltens der zumindest einen Limitation;

Änderung des voreingestellten Parameterwertes basierend auf der Art des Nichteinhaltens.

2. Verfahren nach Anspruch 1, wobei die Art des Nichteinhaltens angibt, welche der Limitationen nicht eingehalten worden ist und/oder um welchen quantitativen Wert die zumindest eine Limitation nicht eingehalten worden ist.

3. Verfahren nach einem der voranstehenden Ansprüche, wobei die Änderung des voreingestellten Parameterwertes von einem Bediener vorgenommen wird.

4. Verfahren nach Anspruch 3,

wobei die vom Bediener auf der Basis der Art der Limitation gewählte Änderung des voreingestellten Parameterwertes zum Trainieren eines Auswahlalgorithmus verwendet wird.

5. Verfahren nach einem der Ansprüche 3 oder 4, wobei dem Bediener zur Änderung des voreingestellten Parameterwertes eine Auswahl an Optionen bereitgestellt wird, wobei jede Option eine jeweilige Änderung des voreingestellten Parameterwertes vorsieht,

wobei jeder Option ein dem Bediener bereitgestelltes Qualitätsmerkmal einer Magnetresonanzabbildung zugeordnet ist, das bei Auswahl der Option durch den entsprechend geänderten Parameterwert erreichbar ist.

6. Verfahren nach einem der voranstehenden Ansprüche, wobei zur Änderung des voreingestellten Parameterwertes ein Auswahlalgorithmus verwendet wird, der basierend auf von einem Bediener geänderter Parameterwerte für eine bestimmte Art des Nichteinhaltens trainiert worden ist.

7. Verfahren nach einem der vorangehenden Ansprüche, wobei bei dem zumindest einen Sequenzverlauf zumindest ein Korrekturgradient und/oder zumindest ein Kompensationsgradienten berücksichtigt werden.

8. Verfahren nach einem der vorangehenden Ansprüche, wobei der zumindest eine Sequenzverlauf mehrere Zeitpunkte umfasst, wobei zur Feststellung des zulässigen Parameterwerts jeder der Zeitpunkte hinsichtlich der zumindest einen Limitationen untersucht wird.

9. Verfahren nach einem der vorangehenden Ansprüche, wobei zur Ermittlung des zulässigen Parameterwertebereichs verschiedene Testparameterwerte für den Parameterwert ermittelt werden.

10. Verfahren nach einem der vorangehenden Ansprüche, wobei die zumindest eine Limitation mehrere Limitationen umfasst, wobei die mehreren Limitationen in einer vorgegebenen Reihenfolge untersucht werden.

11. Verfahren nach einem der vorangehenden Ansprüche, wobei der zumindest eine Sequenzverlauf einen Teilabschnitt der Sequenz beschreibt.

12. Verfahren nach einem der vorangehenden Ansprüche,
wobei die zumindest eine Limitation zumindest eine absolute Limitation und zumindest eine konservative Limitation umfasst,
wobei die zumindest eine absolute Limitation einen absoluten Parameterwertebereich und die zumindest eine konservative Limitationen einen konservativen Parameterwertebereich festlegen,
wobei in zumindest einem Differenzbereich von absolutem Parameterwertebereich und konservativem Parameterwertebereich zumindest ein zulässiger Teilparameterwertebereich ermittelt wird,
wobei der zulässige Parameterwertebereich den konservativen Parameterwertebereich und den zulässigen Teilparameterwertebereich umfasst.

13. Magnetresonanzvorrichtung umfassend:

eine Limitationsbereitstellungseinheit, die ausgebildet ist, zumindest eine Limitation bereitzustellen,
eine Sequenzparameterbereitstellungseinheit, die ausgebildet ist, mehrere Parameter einer Messsequenz bereitzustellen,
eine Auswahleinheit, die ausgebildet ist, eine Auswahl eines der mehreren Parameter zu ermöglichen,
eine Simulationseinheit, die ausgebildet ist, zumindest einen Sequenzverlauf anhand des zumindest einen ausgewählten Parameters zu ermitteln,
eine Auswerteeinheit, die ausgebildet ist, anhand des zumindest einen zeitlichen Sequenzverlaufs und der zumindest einen Limitation einen zulässigen Parameterwertebereich des ausgewählten Parameters zu ermitteln,
eine Festlegungseinheit, die ausgebildet ist, eine Festlegung eines Parameterwertes innerhalb des zulässigen Parameterwertebereichs zu ermöglichen,
wobei die Magnetresonanzvorrichtung ausgebildet ist, anhand des festgelegten Parameterwertes eine Messdatenaufnahme durchzuführen,
**dadurch gekennzeichnet,**
**dass** die Ermittlung eines zulässigen Parameterwertebereichs des ausgewählten Parameters anhand des zumindest einen Sequenzverlaufs und der zumindest einen Limitation durch eine Auswerteeinheit wenigstens eine Iteration umfasst, wobei die Iteration umfasst:

Simulation der Durchführung des Sequenzverlaufs der Magnetresonanztomographie mit dem voreingestellten Parameterwert;
Abbruch der aktuellen Iteration, wenn bei der Simulation die Limitationen eingehalten werden;
Feststellung der Art des Nichteinhaltens der zumindest einen Limitation;
Änderung des voreingestellten Parameterwertes basierend auf der Art des Nichteinhaltens.

14. Magnetresonanzvorrichtung nach Anspruch 13, das ausgebildet ist ein Verfahren nach einem der Ansprüche 1 bis 12 auszuführen.

15. Computerprogrammprodukt, welches ein Programm umfasst und direkt in einen Speicher einer programmierbaren Recheneinheit einer Magnetresonanzvorrichtung ladbar ist, mit Programmmitteln, um ein Verfahren nach einem der Ansprüche 1 bis 12 auszuführen, wenn das Programm in der Recheneinheit der Magnetresonanzvorrichtung ausgeführt wird.

FIG 1

EP 3 828 578 A1

## FIG 2

L$_{1,...}$ —110

P$_1$ → PW$_1$
P$_2$ → PW$_2$
· · ·
—120

P$_e$ —130

SE$_1$ (PW$_{e, 1}$)
· · ·
—140

R$_e$ —150

PW'$_e$ —160

## FIG 3

# FIG 4

## FIG 5

$PW_{e,1}$ $\longrightarrow$ $SE_{e,1}$ ✓

$PW_{e,2}$ $\longrightarrow$ $SE_{e,2}$ ✗

$PW_{e,3}$ $\longrightarrow$ $SE_{e,3}$ ✗

$PW_{e,4}$ $\longrightarrow$ $SE_{e,4}$ ✓

$PW_{e,5}$ $\longrightarrow$ $SE_{e,5}$ ✓

$PW_{e,6}$ $\longrightarrow$ $SE_{e,6}$ ✗

$PW_{e,7}$ $\longrightarrow$ $SE_{e,7}$ ✗

$PW_{e,8}$ $\longrightarrow$ $SE_{e,8}$ ✗

$PW_{e,9}$ $\longrightarrow$ $SE_{e,9}$ ✓

$PW_{e,10}$ $\longrightarrow$ $SE_{e,10}$ ✓

## FIG 6

$PW_{e,1}$ ✓

$PW_{e,2}$

$PW_{e,3}$ $\longrightarrow$ $SE_{e,3}$ ✓

$PW_{e,4}$ $\longrightarrow$ $SE_{e,4}$ ✗

$PW_{e,5}$

$PW_{e,6}$ $\longrightarrow$ $SE_{e,6}$ ✗

$PW_{e,7}$

$PW_{e,8}$

$PW_{e,9}$

$PW_{e,10}$

FIG 7

$R_{e, abs}$

$R_{e, abs} - R_{e, con}$

$R_{e, con}$

FIG 8

$|G|$

$G_{max}$

$G_{max, 1}$

$SE_3$

$G_{max, 3}$

$G_{max, 2}$

$SE_2$

$SE_1$

$t$

## FIG 9

**EP 3 828 578 A1**

Europäisches Patentamt
European Patent Office
Office européen des brevets

# EUROPÄISCHER RECHERCHENBERICHT

Nummer der Anmeldung

EP 19 21 2030

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 10 2016 207264 A1 (SIEMENS HEALTHCARE GMBH [DE]) 2. November 2017 (2017-11-02) | 1-3,7-15 | INV. G01R33/54 G01R33/28 |
| Y | * Absätze [0003], [0004], [0007] - [0027], [0032] - [0034], [0042] - [0045]; Ansprüche 1-8; Abbildung 2 * | 4-6 | |
| Y | DE 10 2017 215829 A1 (SIEMENS HEALTHCARE GMBH [DE]) 6. Dezember 2018 (2018-12-06) * Absatz [0013] * * Absätze [0013], [0028] * * Absätze [0013], [0028]; Ansprüche 1-3,8,9 * | 4-6 | |
| A | US 6 687 527 B1 (WU DEE H [US] ET AL) 3. Februar 2004 (2004-02-03) * Spalte 2, Zeile 35 - Spalte 5, Zeile 34; Abbildungen 2-4, 6 * * Spalte 13, Zeile 58 - Spalte 16, Zeile 2 * * Spalte 19, Zeile 26 - Spalte 20, Zeile 63; Anspruch 1 * | 1-15 | |

-----

-----

-----

**RECHERCHIERTE SACHGEBIETE (IPC)**

G01R
A61B

Der vorliegende Recherchenbericht wurde für alle Patentansprüche erstellt

| Recherchenort | Abschlußdatum der Recherche | Prüfer |
|---|---|---|
| München | 29. Mai 2020 | Faber-Jurk, Sonja |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

 

& : Mitglied der gleichen Patentfamilie, übereinstimmendes Dokument

EPO FORM 1503 03.82 (P04C03)

23

**ANHANG ZUM EUROPÄISCHEN RECHERCHENBERICHT**
**ÜBER DIE EUROPÄISCHE PATENTANMELDUNG NR.**

EP 19 21 2030

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

29-05-2020

| Im Recherchenbericht angeführtes Patentdokument | Datum der Veröffentlichung | Mitglied(er) der Patentfamilie | Datum der Veröffentlichung |
|---|---|---|---|
| DE 102016207264 A1 | 02-11-2017 | DE 102016207264 A1<br>US 2017315195 A1 | 02-11-2017<br>02-11-2017 |
| DE 102017215829 A1 | 06-12-2018 | CN 109464199 A<br>DE 102017215829 A1<br>US 2019074083 A1 | 15-03-2019<br>06-12-2018<br>07-03-2019 |
| US 6687527 B1 | 03-02-2004 | EP 1423722 A1<br>JP 2005501624 A<br>US 6687527 B1<br>WO 03021284 A1 | 02-06-2004<br>20-01-2005<br>03-02-2004<br>13-03-2003 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102016200549 A1